(19) Europäisches Patentamt
European Patent Office
Office européen des brevets

(11) EP 4 681 843 A1

(12) **EUROPEAN PATENT APPLICATION**
published in accordance with Art. 153(4) EPC

(43) Date of publication:
**21.01.2026 Bulletin 2026/04**

(21) Application number: **24770827.4**

(22) Date of filing: **11.03.2024**

(51) International Patent Classification (IPC):
***B22F 1/00*** *(2022.01)* ***B22F 9/00*** *(2006.01)*
***H01B 1/22*** *(2006.01)* ***H01L 21/52*** *(2006.01)*

(52) Cooperative Patent Classification (CPC):
**B22F 1/00; B22F 9/00; C09J 9/02; H01B 1/22; H01L 21/52**

(86) International application number:
**PCT/JP2024/009235**

(87) International publication number:
**WO 2024/190721 (19.09.2024 Gazette 2024/38)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **14.03.2023 PCT/JP2023/009945**

(71) Applicant: **Kao Corporation**
**Tokyo 103-8210 (JP)**

(72) Inventors:
- **EYAMA, Takaaki**
  **Tokyo 103-8210 (JP)**
- **INAYA, Shuichi**
  **Tokyo 103-8210 (JP)**
- **NAKAGAWA, Haruka**
  **Tokyo 103-8210 (JP)**
- **SUZUKI, Ukyo**
  **Tokyo 103-8210 (JP)**
- **FUKUDA, Taiki**
  **Tokyo 103-8210 (JP)**

(74) Representative: **Hoffmann Eitle**
**Patent- und Rechtsanwälte PartmbB**
**Arabellastraße 30**
**81925 München (DE)**

# (54) COPPER MICROPARTICLE DISPERSION

(57) The present invention relates to a copper fine particle dispersion containing copper nanoparticles A, modified cellulose B, and a dispersion medium C. The average particle size of the copper nanoparticles A is 50 nm or more and 350 nm or less. The content of the modified cellulose B in the copper fine particle dispersion is 2,500 ppm by mass or less. The modified cellulose B is in the form of anion-modified cellulose fibers with modifying groups. The modifying groups include one or more selected from the group consisting of a hydrocarbon group (a) and a polymer group (b). The present invention also relates to a method for producing a bonded body by using the copper fine particle dispersion.

EP 4 681 843 A1

## Description

### Technical Field

The present invention relates to a copper fine particle dispersion and a method for producing a bonded body by using the copper fine particle dispersion.

### Background Art

In recent years, semiconductor devices called power devices have been increasingly important as power conversion and control devices, e.g., inverters. Unlike semiconductor devices for information processing such as memories and microprocessors, the power devices are designed to control a high current and will generate a large amount of heat during operation. Moreover, in terms of high efficiency and space saving of the semiconductor devices, a plurality of semiconductor devices may be mounted on a substrate that is composed of a ceramic plate and copper provided on both sides of the ceramic plate.

In this case, a bonding material is used to bond the semiconductor devices and the substrate, and is responsible for heat dissipation and electrical conduction. The bonding material is required to have high bonding strength and high heat resistanoe. Usually, such a bonding material is, e.g., in the form of paste and applied to the substrate by printing.

As the bonding material, a metal fine particle dispersion has been widely used, in which metal fine particles are dispersed in a dispersion medium. When the metal fine particle dispersion is sintered, the metal fine particles are sintered to form a metal continuous body, or a so-called metal bonded body, and the metal bonded body joins the objects to be bonded. From the viewpoint of heat dissipation and electrical conduction, silver or copper is mainly used as the metal species of the metal fine particle dispersion.

On the other hand, as described above, the amount of heat generated by the power devices during operation has been further increased in recent years, and the heat is said to reach as high as 250°C. Under these circumstances, a silver bonded body, which is obtained by sintering a silver fine particle dispersion, is found susceptible to structural changes and becomes brittle, probably due to a large diffusion coefficient of silver atoms. Accordingly, a copper fine particle dispersion is expected because it has a lower diffusion coefficient and is less likely to undergo structural changes, compared to the silver fine particle dispersion.

For example, JP 2022-013164 A (Patent Document 1) aims to provide a copper paste capable of forming a thick conductor film with a low volume resistivity even by screen printing, and proposes a copper paste for forming a conductor. The copper paste contains spherical copper-containing particles (A) having a median diameter of 2.0 μm or more and less than 10.0 pm, spherical copper-containing particles (B) having a median diameter of 0.1 μm or more and less than 2.0 pm, flat copper-containing particles (C) having a median diameter of 0.03 pm or more and less than 3.0 pm, and a dispersion medium.

### Description of the Invention

The present invention relates to a copper fine particle dispersion containing copper nanoparticles A, modified cellulose B, and a dispersion medium C. An average particle size of the copper nanoparticles A is 50 nm or more and 350 nm or less. A content of the modified cellulose B in the copper fine particle dispersion is 2,500 ppm by mass or less. The modified cellulose B is in the form of anion-modified cellulose fibers with modifying groups. The modifying groups include one or more selected from the group consisting of a hydrocarbon group (a) and a polymer group (b).

### Description of the Invention

When a conventional bonding material is printed on a substrate, the bonding material may flow out of the desired printing area, causing short circuits between semiconductor devices. Therefore, there is a demand for a bonding material with excellent printing dimensional properties such that the bonding material can be precisely printed within the desired printing area. For this purpose, the bonding material contains an agent for imparting thixotropy to the bonding material, i.e., a so-called thixotropic agent. The copper paste of Patent Document 1 also contains ethyl cellulose as a thixotropic agent in addition to the copper-containing particles and the dispersant.

However, when the copper paste of Patent Document 1 is used as a bonding material, although the shape of the printed pattern is relatively well maintained, the thixotropic agent may inhibit the sintering of the copper particles, resulting in low sinterability and poor bonding strength.

To deal with this issue, further improvement is needed to enable both printing dimensional properties of the copper fine particle dispersion and bonding strength.

The present invention relates to a copper fine particle dispersion that has excellent printing dimensional

properties and is able to form a bonded body with high bonding strength, and a method for producing a bonded body by using the copper fine particle dispersion.

The present inventors found that a copper fine particle dispersion would have excellent printing dimensional properties and would be able to form a bonded body with high bonding strength, provided that the copper fine particle dispersion contains copper nanoparticles A, modified cellulose B, and a dispersion medium C, the average particle size of the copper nanoparticles A is set within a predetermined range, the content of the modified cellulose B in the copper fine particle dispersion is equal to or less than a predetermined value, the modified cellulose B is in the form of anion-modified cellulose fibers with modifying groups, and the modifying groups include one or more selected from the group consisting of a hydrocarbon group (a) and a polymer group (b).

The present invention relates to the following [1] to [5].

[1] A copper fine particle dispersion containing copper nanoparticles A, modified cellulose B, and a dispersion medium C,

wherein an average particle size of the copper nanoparticles A is 50 nm or more and 350 nm or less,
a content of the modified cellulose B in the copper fine particle dispersion is 2,500 ppm by mass or less,
the modified cellulose B is in the form of anion-modified cellulose fibers with modifying groups, and
the modifying groups include one or more selected from the group consisting of a hydrocarbon group (a) and a polymer group (b).

[2] A copper fine particle dispersion containing copper nanoparticles A, modified cellulose B, and a dispersion medium C,

wherein an average particle size of the copper nanoparticles A is 50 nm or more and 350 nm or less,
a content of the modified cellulose B in the copper fine particle dispersion is 2,500 ppm by mass or less,
the modified cellulose B is in the form of anion-modified cellulose fibers with modifying groups,
the modifying groups include one or more selected from the group consisting of a hydrocarbon group (a) and a polymer group (b),
the modified cellulose B includes one or more types of modified cellulose fibers (I) selected from the group consisting of modified cellulose fibers (BI) having the modifying groups bound via ionic bonds to anionic groups of the anion-modified cellulose fibers and modified cellulose fibers (BII) having the modifying groups introduced by amidation of carboxy groups that are anionic groups of the anion-modified cellulose fibers, and
a degree of crystallinity of the modified cellulose fibers (I) is 20% or more and 90% or less.

[3] A copper fine particle dispersion containing copper nanoparticles A, modified cellulose B, a dispersion medium C, and copper microparticles,

wherein an average particle size of the copper nanoparticles A is 50 nm or more and 350 nm or less,
a content of the modified cellulose B in the copper fine particle dispersion is 2,500 ppm by mass or less,
the modified cellulose B is in the form of anion-modified cellulose fibers with modifying groups,
the modifying groups include one or more selected from the group consisting of a hydrocarbon group (a) and a polymer group (b),
the modified cellulose B includes one or more types of modified cellulose fibers (I) selected from the group consisting of modified cellulose fibers (BI) having the modifying groups bound via ionic bonds to anionic groups of the anion-modified cellulose fibers and modified cellulose fibers (BII) having the modifying groups introduced by amidation of carboxy groups that are anionic groups of the anion-modified cellulose fibers,
a degree of crystallinity of the modified cellulose fibers (I) is 20% or more and 90% or less, and
an average particle size of the copper microparticles is more than 0.35 pm and 10 pm or less.

[4] A method for producing a bonded body, including:
heating multiple metal members with the copper fine particle dispersion according to any one of [1] to [3] interposed between the adjacent metal members.
[5] Use of the copper fine particle dispersion according to any one of [1] to [3] as a bonding material paste.

The present invention provides a copper fine particle dispersion that has excellent printing dimensional

properties and is able to form a bonded body with high bonding strength, and a method for producing a bonded body by using the copper fine particle dispersion.

[Copper fine particle dispersion]

A copper fine particle dispersion of the present invention contains copper nanoparticles A, modified cellulose B, and a dispersion medium C. The average particle size of the copper nanoparticles A is 50 nm or more and 350 nm or less. The content of the modified cellulose B in the copper fine particle dispersion is 2,500 ppm by mass or less. The modified cellulose B is in the form of anion-modified cellulose fibers with modifying groups. The modifying groups include one or more selected from the group consisting of a hydrocarbon group (a) and a polymer group (b).
The copper fine particle dispersion of the present invention has the effects of improving the printing dimensional properties and being able to form a bonded body with high bonding strength. The reason for this is not fully clear, but can be assumed as follows.
The copper fine particle dispersion of the present invention contains the modified cellulose B in the form of anion-modified cellulose fibers with modifying groups, and the modifying groups include one or more selected from the group consisting of a hydrocarbon group (a) and a polymer group (b). This configuration imparts thixotropy to the copper fine particle dispersion, and thus allows the copper fine particle dispersion to have excellent printing dimensional properties. On the other hand, since the content of the modified cellulose B in the copper fine particle dispersion is 2,500 ppm by mass or less, it is possible to increase the percentage of the copper nanoparticles A in the copper fine particle dispersion and to prevent a disorderly arrangement of the copper nanoparticles A. Moreover, the use of the copper nanoparticles A with an average particle size of 50 nm or more and 350 nm or less facilitates the fusion of the copper nanoparticles A in forming a bonded body, so that the bonding strength of the bonded body can be increased. Therefore, the copper fine particle dispersion of the present invention can achieve both excellent printing dimensional properties and high bonding strength.
In the present specification, the term "printing dimensional properties" is used as an indicator of the degree of deviation of the copper fine particle dispersion from the printing area when the copper fine particle dispersion is printed, and may be measured by a method as described in Examples below. The smaller the degree of deviation of the copper fine particle dispersion, the better. In the present specification, the term "250°C heat resistance" refers to the bonding properties of the bonded body that has been obtained by sintering the copper fine particle dispersion and stored in an environment of 250°C for 1000 hours.

<Copper nanoparticles A>

The copper fine particle dispersion of the present invention contains copper nanoparticles A.
The content of copper in the copper nanoparticles A is preferably 95% by mass or more, more preferably 98% by mass or more, even more preferably 99% by mass or more, and still more preferably substantially 100% by mass from the viewpoint of increasing the bonding strength and 250°C heat resistance of the bonded body obtained from the copper fine particle dispersion.
In the present specification, the term "substantially 100% by mass" means that the copper nanoparticles A may contain unintended components. The unintended components may include, e.g., unavoidable impurities.
The average particle size of the copper nanoparticles A is 50 nm or more, preferably 100 nm or more, more preferably 105 nm or more, even more preferably 110 nm or more, still more preferably 115 nm or more, and yet more preferably 120 nm or more from the viewpoint of improving the printing dimensional properties of the copper fine particle dispersion and increasing the bonding strength and 250°C heat resistance of the bonded body obtained from the copper fine particle dispersion. Furthermore, the average particle size of the copper nanoparticles A is 350 nm or less, preferably 270 nm or less, more preferably 250 nm or less, even more preferably 240 nm or less, still more preferably 230 nm or less, and yet more preferably 220 nm or less from the viewpoint of improving the printing dimensional properties of the copper fine particle dispersion and increasing the bonding strength and 250°C heat resistance of the bonded body obtained from the copper fine particle dispersion.
The average particle size of the copper nanoparticles A may be measured by a method as described in Examples below.
The average particle size of the copper nanoparticles A can be adjusted by, e.g., the production conditions of the copper nanoparticles A, including the reduced metal ratio and the reduction temperature.
The content of the copper nanoparticles A in the copper fine particle dispersion of the present invention is preferably 30% by mass or more, more preferably 40% by mass or more, even more preferably 50% by mass or more, and still more preferably 52% by mass or more from the viewpoint of increasing the bonding strength and 250°C heat resistance of the bonded body obtained from the copper fine particle dispersion. Furthermore, the content of the copper nanoparticles A is preferably 95% by mass or less, more preferably 94% by mass or less, and even more preferably 93% by mass or less from the viewpoint of improving the printing dimensional properties of the copper fine particle dispersion.

<Dispersant D>

The copper nanoparticles A of the present invention are preferably dispersed with a dispersant D from the viewpoint of improving the dispersion stability of the copper nanoparticles A, preventing uneven distribution of the copper nanoparticles A due to aggregation during the formation of a bonded body, and increasing the bonding strength of the bonded body obtained from the copper fine particle dispersion of the present invention.
The dispersant D is preferably one or more selected from the group consisting of a low molecular weight dispersant with a carboxy group and a polymer dispersant with a hydrophilic group from the viewpoint of improving the dispersion stability of the copper nanoparticles A and increasing the bonding strength of the bonded body obtained from the copper fine particle dispersion.
The low molecular weight dispersant with a carboxy group is preferably, e.g., one or more selected from the group consisting of aliphatic carboxylic acid having 1 to 24 carbon atoms and aliphatic hydroxycarboxylic acid having 2 to 34 carbon atoms.
The molecular weight of the low molecular weight dispersant is preferably 100 or more, and more preferably 150 or more, and is also preferably 1,000 or less, more preferably 800 or less, even more preferably 600 or less, and still more preferably 400 or less.
The polymer dispersant with a hydrophilic group is preferably a polymer having one or more selected from the group consisting of a nonionic group, a cationic group, and an anionic group from the viewpoint of improving the dispersion stability of the copper nanoparticles A and increasing the bonding strength of the bonded body obtained from the copper fine particle dispersion. The hydrophilic group is more preferably attached to the side chain of the polymer.
Examples of the hydrophilic group include: nonionic groups, e.g., hydroxy group, amide group, and oxyalkylene group; cationic groups, e.g., amino group; and anionic groups, e.g., carboxy group, sulfonic acid group, and phosphate group.
The polymer having a nonionic group may be, e.g., a polyvinyl alcohol, polyvinylpyrrolidone, or polyacrylamide.
The polymer having a cationic group may be, e.g., polyallylamine or polyethyleneimine.
The polymer having an anionic group is preferably a polymer having a carboxy group. Examples of the basic structure of the polymer having a carboxy group include: vinyl polymers, e.g., acrylic resin, styrene resin, styrene-acrylic resin, and acrylic silicone resin; and condensation polymers, e.g., polyester and polyurethane.
The polymer dispersant with a hydrophilic group may be either an appropriately synthesized product or a commercially available product.
In particular, the dispersant D is preferably a vinyl polymer P containing a constitutional unit derived from a monomer (p-1) having a carboxy group and a constitutional unit derived from a monomer (p-2) having a polyalkylene glycol segment from the viewpoint of improving the dispersion stability of the copper nanoparticles A and increasing the bonding strength of the bonded body obtained from the copper fine particle dispersion. The vinyl polymer P may be any of a random copolymer, a block copolymer, and an alternating copolymer.

[Monomer (p-1) having carboxy group]

Preferred examples of the monomer (p-1) include: unsaturated monocarboxylic acids, e.g., (meth)acrylic acid, crotonic acid, and 2-methacryloyloxymethylsuccinic acid; and unsaturated dicarboxylic acids, e.g., maleic acid, itaconic acid, fumaric acid, and citraconic acid. The unsaturated dicarboxylic acid may be an anhydride.
The monomer (p-1) may be used alone or in combination of two or more types.
The monomer (p-1) is preferably at least one selected from the group consisting of (meth)acrylic acid and maleic acid, more preferably (meth)acrylic acid, and even more preferably methacrylic acid from the viewpoint of improving the dispersion stability of the copper nanoparticles A and increasing the bonding strength of the bonded body obtained from the copper fine particle dispersion.
In the present specification, the term "(meth)acrylic acid" means at least one selected from the group consisting of acrylic acid and methacrylic acid.

[Monomer (p-2) having polyalkylene glycol segment]

Examples of the monomer (p-2) include polyalkylene glycol (meth)acrylate, alkoxy polyalkylene glycol (meth) acrylate, and phenoxy polyalkylene glycol (meth)acrylate.
The monomer (p-2) may be used alone or in combination of two or more types.
In the present specification, the term "(meth)acrylate" means at least one selected from the group consisting of acrylate and methacrylate.
The monomer (p-2) is preferably at least one selected from the group consisting of polyalkylene glycol (meth) acrylate and alkoxy polyalkylene glycol (meth)acrylate, and more preferably alkoxy polyalkylene glycol (meth)acrylate

from the viewpoint of improving the dispersion stability of the copper nanoparticles A and increasing the bonding strength of the bonded body obtained from the copper fine particle dispersion. From the same viewpoint, the number of carbon atoms in an alkoxy group of the alkoxy polyalkylene glycol (meth)acrylate is preferably 18 or less, more preferably 14 or less, and even more preferably 12 or less.

Preferred examples of the alkoxy polyalkylene glycol (meth)acrylate include methoxy polyalkylene glycol (meth) acrylate, ethoxy polyalkylene glycol (meth)acrylate, propoxy polyalkylene glycol (meth)acrylate, butoxy polyalkylene glycol (meth)acrylate, octoxy polyalkylene glycol (meth)acrylate, and lauroxy polyalkylene glycol (meth)acrylate. Among these, methoxy polyalkylene glycol (meth)acrylate is more preferred

The polyalkylene glycol segment of the monomer (p-2) preferably contains a unit derived from alkylene oxide having 2 to 4 carbon atoms from the viewpoint of improving the dispersion stability of the copper nanoparticles A and increasing the bonding strength of the bonded body obtained from the copper fine particle dispersion. The alkylene oxide may be, e.g., ethylene oxide, propylene oxide, or butylene oxide, and is preferably at least one selected from the group consisting of ethylene oxide and propylene oxide, and more preferably ethylene oxide.

The number of units derived from the alkylene oxide in the polyalkylene glycol segment is preferably 2 or more, more preferably 3 or more, and even more preferably 4 or more, and is also preferably 100 or less, more preferably 70 or less, even more preferably 50 or less, still more preferably 40 or less, and yet more preferably 35 or less from the viewpoint of improving the dispersion stability of the copper nanoparticles A and increasing the bonding strength of the bonded body obtained from the copper fine particle dispersion.

The polyalkylene glycol segment may be a copolymer containing a unit derived from ethylene oxide and a unit derived from propylene oxide from the viewpoint of improving the dispersion stability of the copper nanoparticles A and increasing the bonding strength of the bonded body obtained from the copper fine particle dispersion.

The copolymer containing the unit derived from ethylene oxide and the unit derived from propylene oxide may be any of a random copolymer, a block copolymer, and an alternating copolymer.

Specific examples of commercially available monomers (p-2) include: NK ESTER AM-90G, NK ESTER AM-130G, NK ESTER AM-230G, NK ESTER AMP-20GY, NK ESTER M-20G, NK ESTER M-40G, NK ESTER M-90G, and NK ESTER M-230G, all of which are manufactured by SHIN-NAKAMURA CHEMICAL Co., Ltd.; and BLEMMER PE-90, BLEMMER PE-200, BLEMMER PE-350, BLEMMER PME-100, BLEM M ER PM E-200, BLEMMER PME-400, BLEMMER PME-1000, BLEMMER PM E-4000, BLEMMER PP-500, BLEMMER PP-500D, BLEMMER PP-800, BLEMMER PP-1000, BLEMMER PP-2000D, BLEMMER AP-150, BLEMMER AP-400, BLEMMER AP-550, BLEMMER 50PEP-300, BLEMMER 50POEP-800B, BLEMMER 43PAPE-600B, and BLEMMER PLE-1300, all of which are manufactured by NOF CORPORATION.

[Hydrophobic monomer (p-3)]

The vinyl polymer P may contain a constitutional unit derived from a hydrophobic monomer (p-3) from the viewpoint of increasing the bonding strength of the bonded body obtained from the copper fine particle dispersion.

In the present specification, the term "hydrophobic monomer" means that the amount of the monomer dissolved to saturation in 100 g of ion-exchanged water at 25°C is less than 10 g. The amount of the monomer (p-3) dissolved is preferably 5 g or less, and more preferably 1 g or less from the viewpoint of increasing the bonding strength of the bonded body obtained from the copper fine particle dispersion.

The monomer (p-3) is preferably at least one selected from the group consisting of an aromatic group-containing monomer and (meth)acrylate having a hydrocarbon group derived from an aliphatic alcohol.

The aromatic group-containing monomer is preferably a vinyl monomer that has an aromatic group having 6 to 22 carbon atoms and may have a substituent containing a hetero atom, and more preferably at least one selected from the group consisting of a styrene-based monomer and aromatic group-containing (meth)acrylate from the viewpoint of increasing the bonding strength of the bonded body obtained from the copper fine particle dispersion. The molecular weight of the aromatic group-containing monomer is preferably less than 500.

The styrene-based monomer is preferably, e.g., at least one selected from the group consisting of styrene, α-methylstyrene, 2-methylstyrene, 4-vinyltoluene (4-methylstyrene), and divinylbenzene. The styrene-based monomer is more preferably at least one selected from the group consisting of styrene and α-methylstyrene, and even more preferably styrene from the viewpoint of increasing the bonding strength of the bonded body obtained from the copper fine particle dispersion.

The aromatic group-containing (meth)acrylate is preferably, e.g., at least one selected from the group consisting of phenyl (meth)acrylate, benzyl (meth)acrylate, and phenoxyethyl (meth)acrylate, and more preferably benzyl (meth) acrylate from the viewpoint of increasing the bonding strength of the bonded body obtained from the copper fine particle dispersion.

The (meth)acrylate having a hydrocarbon group derived from an aliphatic alcohol preferably has a hydrocarbon group derived from an aliphatic alcohol having 22 or less carbon atoms, more preferably has a hydrocarbon group derived

from an aliphatic alcohol having 12 or less carbon atoms, even more preferably has a hydrocarbon group derived from an aliphatic alcohol having 8 or less carbon atoms, and still more preferably has a hydrocarbon group derived from an aliphatic alcohol having 4 or less carbon atoms from the viewpoint of increasing the bonding strength of the bonded body obtained from the copper fine particle dispersion. The (meth)acrylate having a hydrocarbon group derived from an aliphatic alcohol may be, e.g., at least one selected from the group consisting of (meth)acrylate having a linear alkyl group, (meth)acrylate having a branched alkyl group, and (meth)acrylate having an alicyclic alkyl group.

Preferred examples of the (meth)acrylate having a linear alkyl group include methyl (meth)actylate, ethyl (meth)acrylate, propyl (meth)acrylate, butyl (meth)acrylate, pentyl (meth)acrylate, octyl (meth)acrylate, decyl (meth)acrylate, dodecyl (meth)acrylate, and stearyl (meth)acrylate. Among these, methyl (meth)acrylate is more preferred.

Preferred examples of the (meth)acrylate having a branched alkyl group include isopropyl (meth)acrylate, isobutyl (meth)acrylate, tert-butyl (meth)acrylate, isopentyl (meth)acrylate, isooctyl (meth)acrylate, isodecyl (meth)acrylate, isododecyl (meth)acrylate, isostearyl (meth)acrylate, and 2-ethylhexyl (meth)acrylate.

Preferred examples of the (meth)acrylate having an alicyclic alkyl group include cyclohexyl (meth)acrylate.

The monomer (p-3) may be used alone or in combination of two or more types.

From the viewpoint of increasing the bonding strength of the bonded body obtained from the copper fine particle dispersion, the monomer (p-3) is preferably at least one selected from the group consisting of the aromatic group-containing monomer and the (meth)acrylate having a linear alkyl group, more preferably at least one selected from the group consisting of the styrene-based monomer and the (meth)acrylate having a linear alkyl group having 1 to 4 carbon atoms, even more preferably at least one selected from the group consisting of styrene, α-methylstyrene, 2-methylstyrene, 4-vinyltoluene (4-methylstyrene), methyl (meth)acrylate, ethyl (meth)acrylate, propyl (meth)acrylate, and butyl (meth)acrylate, still more preferably at least one selected from the group consisting of styrene, α-methylstyrene, and methyl (meth)acrylate, and yet more preferably at least one selected from the group consisting of styrene and methyl (meth)acrylate.

The vinyl polymer P more preferably contains a constitutional unit derived from at least one selected from the group consisting of (meth)acrylic acid and maleic acid as the monomer (p-1) and a constitutional unit derived from alkoxy polyalkylene glycol (meth)acrylate as the monomer (p-2) from the viewpoint of improving the dispersion stability of the copper nanoparticles A and increasing the bonding strength of the bonded body obtained from the copper fine particle dispersion.

The content of the monomer (p-1) in the raw material monomers used in the production of the vinyl polymer P or the content of the constitutional unit derived from the monomer (p-1) in all the constitutional units of the vinyl polymer P is preferably 3% by mass or more, and more preferably 5% by mass or more, and is also preferably 35% by mass or less, more preferably 25% by mass or less, and even more preferably 18% by mass or less from the viewpoint of improving the dispersion stability of the copper nanoparticles A and increasing the bonding strength of the bonded body obtained from the copper fine particle dispersion.

The content of the monomer (p-2) in the raw material monomers used in the production of the vinyl polymer P or the content of the constitutional unit derived from the monomer (p-2) in all the constitutional units of the vinyl polymer P is preferably 55% by mass or more, more preferably 60% by mass or more, and even more preferably 65% by mass or more, and is also preferably 97% by mass or less, and more preferably 95% by mass or less from the viewpoint of improving the dispersion stability of the copper nanoparticles A and increasing the bonding strength of the bonded body obtained from the copper fine particle dispersion.

When the vinyl polymer P contains the constitutional units derived from the monomer (p-1), the monomer (p-2), and the monomer (p-3), the content of the monomer (p-1) in the raw material monomers used in the production of the vinyl polymer P or the content of the constitutional unit derived from the monomer (p-1) in all the constitutional units of the vinyl polymer P is preferably 3% by mass or more, more preferably 9% by mass or more, and even more preferably 13% by mass or more, and is also preferably 35% by mass or less, more preferably 25% by mass or less, and even more preferably 18% by mass or less from the same viewpoint as described above.

When the vinyl polymer P contains the constitutional units derived from the monomer (p-1), the monomer (p-2), and the monomer (p-3), the content of the monomer (p-2) in the raw material monomers used in the production of the vinyl polymer P or the content of the constitutional unit derived from the monomer (p-2) in all the constitutional units of the vinyl polymer P is preferably 55% by mass or more, more preferably 60% by mass or more, and even more preferably 65% by mass or more, and is also preferably 92% by mass or less, more preferably 85% by mass or less, even more preferably 80% by mass or less, still more preferably 75% by mass or less, and yet more preferably 70% by mass or less from the same viewpoint as described above.

When the vinyl polymer P contains the constitutional units derived from the monomer (p-1), the monomer (p-2), and the monomer (p-3), the content of the monomer (p-3) in the raw material monomers used in the production of the vinyl polymer P or the content of the constitutional unit derived from the monomer (p-3) in all the constitutional units of the vinyl polymer P is preferably 5% by mass or more, more preferably 10% by mass or more, and even more preferably 15% by mass or more, and is also preferably 30% by mass or less, more preferably 25% by mass or less, and even more preferably

20% by mass or less from the same viewpoint as described above.

When the vinyl polymer P contains only the constitutional units derived from the monomer (p-1) and the monomer (p-2), the content of the monomer (p-1) in the raw material monomers used in the production of the vinyl polymer P or the content of the constitutional unit derived from the monomer (p-1) in all the constitutional units of the vinyl polymer P is preferably 3% by mass or more, and more preferably 5% by mass or more, and is also preferably 35% by mass or less, more preferably 30% by mass or less, even more preferably 15% by mass or less, and still more preferably 10% by mass or less from the same viewpoint as described above.

When the vinyl polymer P contains only the constitutional units derived from the monomer (p-1) and the monomer (p-2), the content of the monomer (p-2) in the raw material monomers used in the production of the vinyl polymer P or the content of the constitutional unit derived from the monomer (p-2) in all the constitutional units of the vinyl polymer P is preferably 65% by mass or more, more preferably 70% by mass or more, even more preferably 85% by mass or more, and still more preferably 90% by mass or more, and is also preferably 97% by mass or less, and more preferably 95% by mass or less from the same viewpoint as described above.

In the present invention, the total content of the monomer (p-1) and the monomer (p-2) in the raw material monomers used in the production of the vinyl polymer P or the total content of the constitutional unit derived from the monomer (p-1) and the constitutional unit derived from the monomer (p-2) in all the constitutional units of the vinyl polymer P is preferably 58% by mass or more, more preferably 75% by mass or more, and even more preferably 80% by mass or more from the viewpoint of improving the dispersion stability of the copper nanoparticles A and increasing the bonding strength of the bonded body obtained from the copper fine particle dispersion.

The number average molecular weight Mn of the vinyl polymer P is preferably 4,000 or more, more preferably 6,000 or more, and even more preferably 7,000 or more, and is also preferably 50,000 or less, more preferably 30,000 or less, even more preferably 20,000 or less, still more preferably 15,000 or less, and yet more preferably 10,000 or less from the viewpoint of improving the dispersion stability of the copper nanoparticles A and increasing the bonding strength of the bonded body obtained from the copper fine particle dispersion. The number average molecular weight Mn may be measured by a method as described in Examples below.

The acid value of the vinyl polymer P is preferably 20 mgKOH/g or more, more preferably 25 mgKOH/g or more, even more preferably 30 mgKOH/g or more, still more preferably 35 mgKOH/g or more, and yet more preferably 40 mgKOH/g or more, and is also preferably 250 mgKOH/g or less, more preferably 200 mgKOH/g or less, even more preferably 150 mgKOH/g or less, and still more preferably 110 mgKOH/g or less from the viewpoint of improving the dispersion stability of the copper nanoparticles A and increasing the bonding strength of the bonded body obtained from the copper fine particle dispersion.

The acid value of the vinyl polymer P may be measured by a method as described in Examples below, but can also be calculated from the mass ratio of the constituent monomers.

The content of the dispersant D in the copper fine particle dispersion of the present invention is preferably 0.05% by mass or more, more preferably 0.1% by mass or more, even more preferably 0.3% by mass or more, still more preferably 0.4% by mass or more, yet more preferably 0.5% by mass or more, and much more preferably 0.7% by mass or more, and is also preferably 10% by mass or less, more preferably 8% by mass or less, even more preferably 5% by mass or less, still more preferably 3% by mass or less, yet more preferably 2% by mass or less, and much more preferably 1.5% by mass or less from the viewpoint of improving the dispersion stability of the copper nanoparticles A and increasing the bonding strength of the bonded body obtained from the copper fine particle dispersion.

The mass ratio [dispersant D/(oopper nanoparticles A + dispersant D)] of the content of the dispersant D to the total content of the copper nanoparticles A and the dispersant D in the copper fine particle dispersion of the present invention (also referred to as a "dispersant mass ratio" below) is preferably 0.003 or more, more preferably 0.005 or more, even more preferably 0.006 or more, still more preferably 0.008 or more, and yet more preferably 0.010 or more, and is also preferably 0.025 or less, more preferably 0.020 or less, even more preferably 0.018 or less, still more preferably 0.016 or less, and yet more preferably 0.012 or less from the viewpoint of improving the dispersion stability of the copper nanoparticles A and increasing the bonding strength of the bonded body obtained from the copper fine particle dispersion.

The dispersant mass ratio may be calculated from the content of the copper nanoparticles A and the content of the dispersant D in the copper fine particle dispersion, which are measured by a method as described in Examples using a simultaneous thermogravimetric and differential thermal analyzer (TG/DTA).

<Modified cellulose B>

The copper fine particle dispersion of the present invention contains modified cellulose B. The modified cellulose B is in the form of anion-modified cellulose fibers with modifying groups. The modifying groups include one or more selected from the group consisting of a hydrocarbon group (a) and a polymer group (b). The modified cellulose B serves to impart thixotropy to the copper fine particle dispersion.

[Anion-modified cellulose fibers]

In the present invention, the "anion-modified cellulose fibers" are cellulose fibers having anionic groups in at least a part of the cellulose fibers.
The anionic group may be, e.g., at least one selected from the group consisting of a carboxy group, a phosphoric (or phosphorous) acid group, and a sulfonic acid group.
The anion-modified cellulose fibers are preferably anion-modified cellulose fibers having carboxy groups as anionic groups from the viewpoint of availability and effectiveness.
The anion-modified cellulose fibers having carboxy groups are preferably carboxy-modified cellulose fibers in which hydroxymethyl groups ($-CH_2OH$) at the C6 positions of the glucose units in cellulose fibers have been selectively converted to carboxy groups, i.e., modified cellulose fibers (also referred to as "carboxy-modified cellulose fibers" below) in which the carbon atoms at the C6 positions of the glucose units in cellulose fibers constitute carboxy group.
The content of the anionic groups in the anion-modified cellulose fibers is preferably 0.1 mmol/g or more, more preferably 0.5 mmol/g or more, and even more preferably 1.0 mmol/g or more from the viewpoint of improving defibration by the introduction of modifying groups. The content of the anionic groups is preferably 3 mmol/g or less, more preferably 2 mmol/g or less, and even more preferably 1.8 mmol/g or less from the viewpoint of ease of production. The content of the anionic groups in the anion-modified cellulose fibers may be measured by a method as described in Examples below.

Hydrocarbon group (a)

The hydrocarbon group (a) may be a monovalent hydrocarbon group and is preferably, e.g., one or more selected from the group consisting of a linear or branched chain saturated hydrocarbon group, a linear or branched chain unsaturated hydrocarbon group, a cyclic saturated hydrocarbon group, an aryl group, an aralkyl group, and a heterocyclic aromatic hydrocarbon group.
The number of carbon atoms of the hydrocarbon group (a) is 1 or more, preferably 3 or more, more preferably 8 or more, and even more preferably 10 or more from the viewpoint of improving the printing dimensional properties of the copper fine particle dispersion. From the same viewpoint, the number of carbon atoms of the hydrocarbon group (a) is preferably 30 or less, more preferably 22 or less, and even more preferably 18 or less.
The linear or branched chain saturated hydrocarbon group is preferably a linear chain saturated hydrocarbon group from the viewpoint of improving the printing dimensional properties of the copper fine particle dispersion. Preferred examples of the linear or branched chain saturated hydrocarbon group include propyl group, isopropyl group, butyl group, sec-butyl group, tert-butyl group, isobutyl group, pentyl group, tert-pentyl group, isopentyl group, hexyl group, isohexyl group, heptyl group, octyl group, 2-ethylhexyl group, nonyl group, decyl group, dodecyl group, tridecyl group, tetradecyl group, octadecyl group, docosyl group, and otaoosanyl group.
Preferred examples of the linear or branched chain unsaturated hydrocarbon group include propenyl group, butenyl group, isobutenyl group, isoprenyl group, pentenyl group, hexenyl group, heptenyl group, octenyl group, nonenyl group, decenyl group, dodecenyl group, tridecenyl group, tetradecenyl group, and octadecenyl group.
Preferred examples of the cyclic saturated hydrocarbon group include cyclopropyl group, cyclobutyl group, cyclopentyl group, cyclohexyl group, cycloheptyl group, cyclooctyl group, cyclononyl group, cyclodecyl group, cyclododecyl group, cyclotridecyl group, cyclotetradecyl group, and cyclooctadecyl group.
Preferred examples of the aryl group include phenyl group, naphthyl group, anthryl group, phenanthryl group, biphenyl group, triphenyl group, terphenyl group, and groups obtained by substituting these groups with substituents as described below.
Preferred examples of the aralkyl group include benzyl group, phenethyl group, phenylpropyl group, phenylpentyl group, phenylhexyl group, phenylheptyl group, phenyloctyl group, and groups obtained by substituting these groups with substituents as described below.
Preferred examples of the heterocyclic aromatic hydrocarbon group include imidazole group, methylimidazole group, ethylimidazole group, propylimidazole group, 2-phenylimidazole group, benzimidazole group, and groups obtained by substituting these groups with substituents as described below.
The hydrocarbon group (a) is preferably introduced by using an amine compound containing the hydrocarbon group (a) as a modifying compound to introduce modifying groups into the anionic groups of the anion-modified cellulose fibers. The amine compound is preferably one or more selected from the group consisting of a primary amine, a secondary amine, a tertiary amine, and a quaternary ammonium compound.

Polymer group (b)

In the present specification, the "polymer group (b)" is a functional group containing two or more repeating units, which are identical constitutional units. The polymer group (b) of the present invention excludes the hydrocarbon group (a).

The formula weight (molecular weight) of the polymer group (b) is preferably 100 or more, more preferably 500 or more, even more preferably 1,000 or more, and still more preferably 1,500 or more, and is also preferably 1,000,000 or less, more preferably 100,000 or less, even more preferably 10,000 or less, still more preferably 7,000 or less, yet more preferably 5,000 or less, much more preferably 4,000 or less, further preferably 3,500 or less, and even further preferably 2,500 or less from the viewpoint of improving the printing dimensional properties of the copper fine particle dispersion.

From the viewpoint of improving the printing dimensional properties of the copper fine particle dispersion, the polymer group (b) is preferably a functional group having repeating units linked by a structure containing an oxygen atom, more preferably a functional group having repeating units linked by an oxygen atom, e.g., a functional group having a polyoxyalkylene structure or a polysiloxane structure, even more preferably a functional group having a polyoxyalkylene structure, and still more preferably an alkoxypolyoxyalkylene group.

From the viewpoint of improving the printing dimensional properties of the copper fine particle dispersion, the polyoxyalkylene structure is preferably a (oo)polymer structure of one or more types of oxyalkylene selected from the group consisting of oxyalkylene having 2 to 8 carbon atoms, more preferably a (co)polymer structure of one or more types of oxyalkylene selected from the group consisting of oxyalkylene having 2 to 4 carbon atoms, even more preferably a (co) polymer structure of one type or two types of oxyalkylene selected from the group consisting of ethylene oxide (also referred to as "EO" below) and propylene oxide (also referred to as ''PO" below), and still more preferably a copolymer structure in which ethylene oxide and propylene oxide are polymerized in a random or block form (also referred to as an "EO/PO copolymer structure" below).

The polymer group (b) is preferably introduced by using an amine compound containing the polymer group (b) as a modifying compound. When the modifying groups of the present invention include the polymer group (b), the modifying groups are preferably derived from the amine compound containing the polymer group (b). The amine compound is preferably one or more selected from the group consisting of a primary amine, a secondary amine, a tertiary amine, and a quaternary ammonium compound.

When the polymer group (b) is derived from an amine compound containing the EO/PO copolymer structure, a suitable structure of the amine compound containing the polymer group (b) may be represented by the following formula (1).

[Chemical Formula 1]

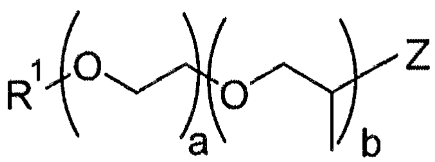 (1)

In the formula (1), $R^1$ represents a hydrogen atom or a hydrocarbon group having 1 to 6 carbon atoms, EO-derived units and PO-derived units are present in a random or block form, a represents a positive number indicating the average number of moles of EO added, and b represents a positive number indicating the average number of moles of PO added.

In the formula (1), Z represents an amino group that is at one end of the EO/PO copolymer.

From the viewpoint of improving the printing dimensional properties of the copper fine particle dispersion, $R^1$ is preferably a linear or branched alkyl group having 1 to 6 carbon atoms, and more preferably a methyl group.

In the formula (1), a is preferably 1 or more, more preferably 3 or more, even more preferably 6 or more, still more preferably 11 or more, yet more preferably 15 or more, much more preferably 20 or more, further preferably 25 or more, and even further preferably 30 or more from the viewpoint of improving the printing dimensional properties of the copper fine particle dispersion. From the same viewpoint, a is preferably 100 or less, more preferably 70 or less, even more preferably 60 or less, still more preferably 50 or less, yet more preferably 40 or less, and much more preferably 35 or less.

In the formula (1), b is preferably 1 or more, more preferably 3 or more, and even more preferably 5 or more, and is also preferably 50 or less, more preferably 40 or less, even more preferably 30 or less, still more preferably 25 or less, yet more preferably 20 or less, much more preferably 15 or less, and further preferably 10 or less from the viewpoint of improving the printing dimensional properties of the copper fine particle dispersion.

In the formula (1), the sum of a and b (a+b) represents the average number of moles of EO and PO added in total. The sum of a and b is preferably 4 or more, more preferably 6 or more, even more preferably 8 or more, still more preferably 10 or more, yet more preferably 20 or more, and much more preferably 30 or more from the viewpoint of improving the printing dimensional properties of the copper fine particle dispersion. From the same viewpoint, the sum of a and b is preferably 100 or less, more preferably 70 or less, even more preferably 60 or less, and still more preferably 50 or less.

The content (mol%) of the PO-derived units in the EO/PO copolymer structure can be calculated based on a and b

above, and specifically can be determined by b × 100 / (a + b). The content of the PO-derived units is preferably 1 mol% or more, more preferably 5 mol% or more, even more preferably 7 mol% or more, still more preferably 10 mol% or more, and yet more preferably 15 mol% or more from the viewpoint of improving the printing dimensional properties of the copper fine particle dispersion. From the same viewpoint, the content of the PO-derived units is preferably 90 mol% or less, more preferably 85 mol% or less, even more preferably 75 mol% or less, still more preferably 60 mol% or less, yet more preferably 50 mol% or less, much more preferably 40 mol% or less, and further preferably 30 mol% or less.

In the present invention, the modified cellulose B preferably includes one or more types of modified cellulose fibers (I) (also referred to as "modified cellulose fibers (I)" below) selected from the group consisting of modified cellulose fibers (BI) having the modifying groups bound via ionic bonds to anionic groups of the anion-modified cellulose fibers and modified cellulose fibers (BII) having the modifying groups introduced by amidation of carboxy groups that are anionic groups of the anion-modified cellulose fibers.

Due to the above features of the modified cellulose B, the copper nanoparticles A and the ionic binding sites or amide binding sites of the modified cellulose fibers (I) may interact with each other to form a network structure in the copper fine particle dispersion, so that the copper fine particle dispersion can exhibit thixotropy more efficiently.

As described above, power devices generate more and more heat during operation, and the heat can reach as high as 250°C. In this regard, the bonded body may also be required to have heat resistance to be able to maintain high bonding strength even in an environment of 250°C. The use of the copper fine particle dispersion containing the specific copper nanoparticles A and the specific modified cellulose fibers (I) according to the present invention may result in a bonded body with excellent heat resistance that is able to maintain high bonding strength even if the bonded body is stored in an environment of 250°C for a long period of time.

[Modified cellulose fibers (BI)]

In the present invention, the "modified cellulose fibers (BI) having the modifying groups bound via ionic bonds to anionic groups of the anion-modified cellulose fibers" (also referred to as "modified cellulose fibers (BI)" below) are configured so that the anionic groups of the anion-modified cellulose fibers and the modifying groups form the ionic bonds. When the modified cellulose B includes the modified cellulose fibers (BI), the modified cellulose fibers (BI) are preferably salts of the anion-modified cellulose fibers and the modifying compound that constitutes the modifying groups (also referred to as a "modifying compound" below), and more preferably salts of the modifying compound and the carboxy-modified cellulose fibers in which hydroxymethyl groups ($-CH_2OH$) at the C6 positions of the glucose units in cellulose fibers have been selectively converted to carboxy groups, i.e., salts of the modifying compound and the modified cellulose fibers in which the carbon atoms at the C6 positions of the glucose units in cellulose fibers constitute carboxy groups.

(Modifying groups of modified cellulose fibers (BI))

The modifying groups of the modified cellulose fibers (BI) include one or more selected from the group consisting of the hydrocarbon group (a) and the polymer group (b). These modifying groups may be ionically bonded to the anion-modified cellulose fibers either alone or in combination of two or more types.

More suitable ranges of the hydrocarbon group (a) and the polymer group (b) are as described above.

When the modifying groups of the modified cellulose fibers (BI) include the hydrocarbon group (a), the modifying compound is preferably the amine compound containing the hydrocarbon group (a), more preferably one or more selected from the group consisting of a primary amine, a secondary amine, a tertiary amine, and a quaternary ammonium compound, even more preferably a quaternary ammonium compound, and still more preferably tetrabutylammonium hydroxide (TBAH).

When the modifying groups of the modified cellulose fibers (BI) include the polymer group (b) and the polymer group (b) is derived from the amine compound containing the EO/PO copolymer structure, a suitable structure of the amine compound containing the polymer group (b) may be represented by the above formula (1). In this case, the amino group represented by Z in the formula (1) forms an ionic bond with the anionic group that has been introduced into the anion-modified cellulose fibers.

In the formula (1), the chemical structure of the amino group represented by Z, which is at one end of the EO/PO copolymer, is preferably $-NH_2$.

The following formula (2) represents a suitable structure of the modified cellulose fibers (BI), where the functional group at one end of the EO/PO copolymer structure is an amino group, the anion-modified cellulose fibers are carboxy-modified cellulose fibers, and the ionic bond is indicated by Y.

[Chemical Formula 2]

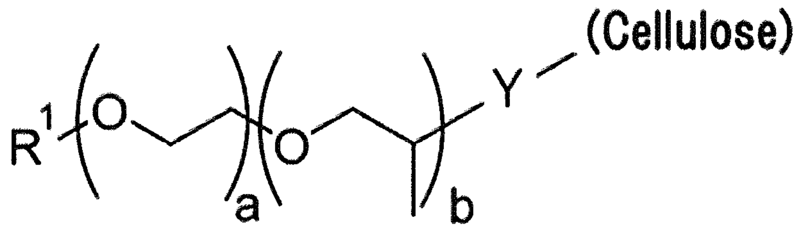

(2)

In the formula (2), $R^1$, a, and b are the same as those in the formula (1), and specific examples or preferred aspects of $R^1$, a, and b are also the same as those in the formula (1). In the formula (2), Y preferably represents $-N^+H_3$-OOC-.

When Y is $-N^+H_3$-OOC-, $-NH_2$ of $-N^+H_3{}^-$OOC- is preferably a group derived from the amino group represented by Z that is at one end of the EO/PO copolymer in the formula (1), and HOOC- of $-N^+H_3{}^-$OOC- is preferably a group derived from the carboxy group of the carboxy-modified cellulose fibers.

When the functional group at one end of the EO/PO copolymer structure is the amino group, commercially available products of the modifying compound include, e.g., Jeffamine M series, manufactured by Huntsman Corporation in the United States.

[Modified cellulose fibers (BII)]

The modified cellulose fibers (BII) (also referred to as "modified cellulose fibers (BII)" below) have the modifying groups introduced by amidation of carboxy groups that are anionic groups of the anion-modified cellulose fibers. The modified cellulose fibers (BII) are preferably produced through the amidation reaction between the above modifying compound and the carboxy-modified cellulose fibers in which hydroxymethyl groups ($-CH_2OH$) at the C6 positions of the glucose units in cellulose fibers have been selectively converted to carboxy groups, i.e., the amidation reaction between the above modifying compound and the modified cellulose fibers in which the carbon atoms at the C6 positions of the glucose units in cellulose fibers constitute carboxy groups.

(Modifying groups of modified cellulose fibers (BII))

The modifying groups of the modified cellulose fibers (BII) include one or more selected from the group consisting of the hydrocarbon group (a) and the polymer group (b), and preferably include the polymer group (b).

More suitable ranges of the hydrocarbon group (a) and the polymer group (b) are as described above.

When the modifying groups of the modified cellulose fibers (BII) include the hydrocarbon group (a), the modifying compound is preferably the amine compound containing the hydrocarbon group (a), more preferably one or more selected from the group consisting of a primary amine and a secondary amine, and even more preferably a primary amine containing a linear or branched chain saturated hydrocarbon group having 3 to 30 carbon atoms.

When the modifying groups of the modified cellulose fibers (BII) include the polymer group (b) and the polymer group (b) is derived from the amine compound containing the EO/PO copolymer structure, a suitable structure of the amine compound containing the polymer group (b) may be represented by the above formula (1). In this case, the amino group represented by Z in the formula (1) forms an amide bond with the anionic group (carboxy group) that has been introduced into the anion-modified cellulose fibers.

The chemical structure of the amino group represented by Z, which is at one end of the EO/PO copolymer, is preferably $-NH_2$.

The following formula (3) represents a suitable structure of the modified cellulose fibers (BII), where the modifying groups of the modified cellulose fibers (BII) include the polymer group (b), the polymer group (b) is derived from the amine compound containing the EO/PO copolymer structure, and the amide bond is indicated by X.

[Chemical Formula 3]

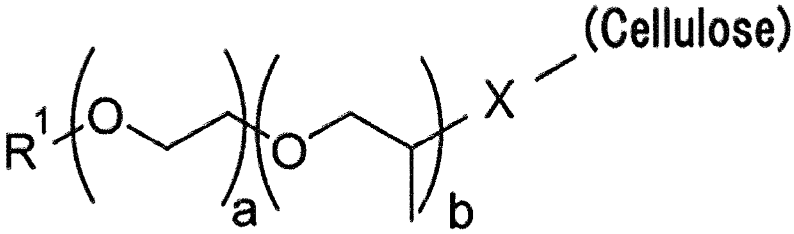

(3)

In the formula (3), $R^1$, a, and b are the same as those in the formula (1), and specific examples or preferred aspects of $R^1$, a, and b are also the same as those in the formula (1). In the formula (3), X represents the amide bond.

The amide bond represented by X is preferably -NH-OC-. In this case, -NH of -NH-OC- is preferably a group derived from the amino group represented by Z that is at one end of the EO/PO copolymer in the formula (1), and OC- of -NH-OC- is preferably a group derived from the carboxy group of the carboxy-modified cellulose fibers.

As described above, from the viewpoint of improving the printing dimensional properties of the copper fine particle dispersion, the modified cellulose B preferably includes one or more types of the modified cellulose fibers (I) selected from the group consisting of the modified cellulose fibers (BI) having the modifying groups bound via ionic bonds to anionic groups of the anion-modified cellulose fibers and the modified cellulose fibers (BII) having the modifying groups introduced by amidation of carboxy groups that are anionic groups of the anion-modified cellulose fibers, more preferably includes the modified cellulose fibers (BII), and even more preferably includes the modified cellulose fibers in which the carbon atoms at the C6 positions of the glucose units in the anion-modified cellulose fibers constitute amide bonds and the modifying groups are bound via the amide bonds.

[Production method of modified cellulose fibers (I)]

A method for producing the modified cellulose fibers (I) as the modified cellulose B preferably includes: producing anion-modified cellulose fibers by introducing anionic groups into raw cellulose fibers (first step); and then introducing modifying groups into the anionic groups of the anion-modified cellulose fibers (second step).

(First step)

<Raw cellulose fibers>

Raw cellulose fibers for the anion-modified cellulose fibers are preferably natural cellulose fibers in view of environmental aspects. Examples of the raw cellulose fibers include: wood pulp, e.g., softwood pulp and hardwood pulp; cotton pulp, e.g., cotton linter and cotton lint; non-wood pulp, e.g., straw pulp and bagasse pulp; and bacterial cellulose. Any of these may be used alone or in combination of two or more types.

The average fiber diameter of the raw cellulose fibers is preferably 5 μm or more from the viewpoint of handle ability and cost. From the same viewpoint, the average fiber diameter of the raw cellulose fibers is preferably 500 μm or less. The average fiber diameter of the raw cellulose fibers may be determined by a method as described in Examples below.

The average fiber length of the raw cellulose fibers is not particularly limited and is preferably 5 pm or more from the viewpoint of availability and cost. From the same viewpoint, the average fiber length of the raw cellulose fibers is preferably 5,000 pm or less. The average fiber length of the raw cellulose fibers may be measured by a method as described in Examples below.

<Introduction method of anionic groups>

There are some methods for introducing carboxy groups as anionic groups into cellulose fibers, e.g., a method that includes oxidizing hydroxy groups of cellulose fibers and converting them to carboxy groups, or a method that includes reacting hydroxy groups of cellulose fibers with at least one selected from the group consisting of a compound having a carboxy group, an acid anhydride of a compound having a carboxy group, and derivatives thereof

The oxidation method of hydroxy groups of cellulose fibers is disclosed in, e.g., JP 2015-143336 A or JP 2015-143337 A. This method includes reacting the raw cellulose fibers with an oxidizing agent such as sodium hypochlorite and a bromide such as sodium bromide using 2,2,6,6-tetramethyl-1-piperidine-N-oxyl (TEMPO) as a

catalyst. In the TEMPO-mediated oxidation of the cellulose fibers, hydroxymethyl groups ($-CH_2OH$) at the C6 positions of the glucose units in the cellulose fibers are selectively converted to carboxy groups (-COOH), and thus the carboxy-modified cellulose fibers can be obtained. In the present invention, carboxy groups are introduced as anionic groups into cellulose fibers preferably by oxidizing the hydroxy groups of the cellulose fibers and converting them to carboxy groups. Moreover, the hydroxy groups of the cellulose fibers are oxidized and converted to carboxy groups preferably by reacting the raw cellulose fibers with an oxidizing agent such as sodium hypochlorite and a bromide such as sodium bromide using 2,2,6,6-tetramethyl-1-piperidine-N-oxyl (TEMPO) as a catalyst.

Sulfonic acid groups may be introduced as anionic groups into cellulose fibers by, e.g., a method that includes adding a sulfuric acid to cellulose fibers and heating the mixture.

Phosphoric (or phosphorous) acid groups may be introduced as anionic groups into cellulose fibers by, e.g., a method that includes mixing dry or wet cellulose fibers with a powder or an aqueous solution of phosphoric (or phosphorous) acid or phosphoric (or phosphorous) acid derivative, or a method that includes adding an aqueous solution of phosphoric (or phosphorous) acid or phosphoric (or phosphorous) acid derivative to a dispersion of cellulose fibers. These methods usually include, e.g., a dehydration treatment and a heat treatment after mixing or adding the powder or aqueous solution of phosphoric (or phosphorous) acid or phosphoric (or phosphorous) acid derivative. In the present specification, the term "phosphoric (or phosphorous) acid" means at least one selected from the group consisting of phosphorous acid and phosphoric acid.

(Second step)

The introduction of modifying groups into the anionic groups of the anion-modified cellulose fibers can be performed through the reaction between the modifying compound for introducing the modifying groups into the anionic groups and the anion-modified cellulose fibers. This reaction produces the modified cellulose fibers (I) as the modified cellulose B. In the introduction of the modifying groups, (1) the method disclosed in JP 2015-143336 A may be used to provide the modified cellulose fibers (BI) in which the modifying groups are bound via ionic bonds to the anionic groups of the anion-modified cellulose fibers, and (2) the method disclosed in JP 2015-143337 A may be used to provide the modified cellulose fibers (BII) in which the modifying groups are introduced by amidation of the carboxy groups that are the anionic groups of the anion-modified cellulose fibers.

After completion of the second step, a post-treatment may be appropriately performed to remove unreacted compounds or the like. The post-treatment may be, e.g., filtration, centrifugation, or dialysis.

(Fibrillation process)

The cellulose fibers are fibrillated at any stage in the production method of the modified cellulose fibers (I), so that the size of the cellulose fibers is reduced from the micrometer scale to the nanometer scale. From the viewpoint of efficient size reduction, the cellulose fibers undergo the fibrillation process preferably before or after the second step, and more preferably after the second step. Moreover, when the average fiber diameter of the cellulose fibers is reduced to the nanometer range, thixotropy can be more effectively imparted to the copper fine particle dispersion.

The fibrillation process may use known fibrillation methods. For example, the cellulose fibers may be treated with, e.g., a grinder such as a mass colloider or a high-pressure homogenizer in a medium to prepare the modified cellulose fibers (I) with an average fiber diameter in the nanometer range.

Preferred examples of the medium include: water; alcohols having 1 to 6 carbon atoms, e.g., methanol, ethanol, propanol, and 1-methoxy-2-propanol (PGME); ketones having 3 to 6 carbon atoms, e.g., acetone, methyl ethyl ketone, methyl isobutyl ketone, and cyclohexanone; esters having 4 to 6 carbon atoms, e.g., ethyl acetate and butyl acetate; saturated or unsaturated hydrocarbons having 5 or 6 carbon atoms; aromatic hydrocarbons, e.g., benzene and toluene; halogenated hydrocarbons, e.g., methylene chloride and chloroform; lower alkyl ethers having 2 to 5 carbon atoms; and polar solvents, e.g., N,N-dimethylformamide (DMF), N,N-dimethylacetamide, and dimethyl sulfoxide. These may be used alone or in combination of two or more types. The amount of the medium used is preferably 1 to 500 mass times the amount of the cellulose fibers.

(Fiber shortening treatment)

The cellulose fibers may be subjected to a fiber shortening treatment at any stage in the production method of the modified cellulose fibers (I).

In the fiber shortening treatment, the target cellulose fibers undergo at least one treatment selected from the group consisting of an alkali treatment, an acid treatment, a heat treatment, an ultraviolet treatment, an electron beam treatment, a mechanical treatment, and an enzyme treatment.

[Properties of modified cellulose fibers (I)]

The main properties of the modified cellulose fibers (I) of the present invention are as follows.

(Crystal structure)

The modified cellulose fibers (I) preferably have a cellulose I crystal structure from the viewpoint of improving the printing dimensional properties of the copper fine particle dispersion.

The degree of crystallinity of the modified cellulose fibers (I) is preferably 20% or more, more preferably 25% or more, even more preferably 30% or more, still more preferably 35% or more, and yet more preferably 40% or more from the viewpoint of improving the printing dimensional properties of the copper fine particle dispersion. Furthermore, the degree of crystallinity of the modified cellulose fibers (I) is preferably 90% or less, more preferably 85% or less, even more preferably 80% or less, still more preferably 75% or less, and yet more preferably 70% or less from the viewpoint of raw material availability. In the present specification, the degree of crystallinity of the modified cellulose fibers (I) is the degree of cellulose I crystallinity calculated from a diffraction intensity value according to an X-ray diffraction method, and may be measured by a method as described in Examples below. The term "cellulose I type" means the crystal form of natural cellulose and the term "degree of cellulose I crystallinity" means the percentage of crystalline regions in the entire cellulose fibers. The presence or absence of the cellulose I crystal structure can be determined by the X-ray diffraction measurement that shows a peak at $2\theta = 22.6°$.

(Average fiber diameter)

The modified cellulose fibers (I) are preferably fibrillated to have diameters in the nanometer range. Therefore, the average fiber diameter of the modified cellulose fibers (I) is preferably 1 nm or more, and more preferably 2 nm or more from the viewpoint of handleability, availability, and cost. Furthermore, the average fiber diameter of the modified cellulose fibers (I) is preferably 300 nm or less, more preferably 200 nm or less, even more preferably 100 nm or less, still more preferably 50 nm or less, yet more preferably 30 nm or less, much more preferably 20 nm or less, further preferably 15 nm or less, even further preferably 10 nm or less, and still further preferably 5 nm or less from the viewpoint of improving handleability, dispersibility, and the printing dimensional properties of the copper fine particle dispersion.

(Average fiber length)

The average fiber length of the modified cellulose fibers (I) is preferably 10 nm or more, more preferably 30 nm or more, even more preferably 50 nm or more, still more preferably 100 nm or more, yet more preferably 200 nm or more, much more preferably 250 nm or more, and further preferably 280 nm or more, and is also preferably 1,000 nm or less, more preferably 500 nm or less, even more preferably 400 nm or less, still more preferably 350 nm or less, and yet more preferably 320 nm or less from the viewpoint of improving the printing dimensional properties of the copper fine particle dispersion.

(Average aspect ratio (average fiber length/average fiber diameter)

The average aspect ratio (average fiber length/average fiber diameter) of the modified cellulose fibers (I) is preferably 5 or more, more preferably 10 or more, even more preferably 30 or more, still more preferably 50 or more, yet more preferably 70 or more, much more preferably 80 or more, and further preferably 90 or more, and is also preferably 300 or less, more preferably 200 or less, even more preferably 120 or less, and still more preferably 100 or less from the viewpoint of improving the printing dimensional properties of the copper fine particle dispersion. More specifically, the average aspect ratio of the modified cellulose fibers (I) is preferably 5 or more and 300 or less, more preferably 10 or more and 200 or less, even more preferably 30 or more and 120 or less, still more preferably 50 or more and 120 or less, yet more preferably 70 or more and 100 or less, much more preferably 80 or more and 95100 or less, and further preferably 90 or more and 100 or less.

The average fiber diameter, average fiber length, and average aspect ratio of the modified cellulose fibers (I) may be determined by methods as described in Examples below.

(Binding amount and introduction rate of modifying groups)

The binding amount of the modifying groups in the modified cellulose fibers (I) is preferably 0.1 mmol/g or more, more preferably 1.0 mmol/g or more, even more preferably 2.0 mmol/g or more, and still more preferably 2.5 mmol/g or more, and is also preferably 5.5 mmol/g or less, more preferably 4.5 mmol/g or less, even more preferably 3.5 mmol/g or

less, still more preferably 3.1 mmol/g or less, yet more preferably 3.0 mmol/g or less, much more preferably 2.9 mmol/g or less, and further preferably 2.8 mmol/g or less from the viewpoint of improving the printing dimensional properties of the copper fine particle dispersion.

The introduction rate of the modifying groups in the modified cellulose fibers (I) is preferably 10 mol% or more, more preferably 20 mol% or more, even more preferably 40 mol% or more, still more preferably 50 mol% or more, and yet more preferably 53 mol% or more from the viewpoint of dispersibility. Furthermore, the introduction rate of the modifying groups in the modified cellulose fibers (I) is preferably 90 mol% or less, more preferably 70 mol% or less, and even more preferably 60 mol% or less from the viewpoint of improving the productivity of the modified cellulose.

The binding amount and the introduction rate of the modifying groups can be adjusted by, e.g., the type and amount of the modifying compound, the reaction temperature, the reaction time, and the type of the solvent. The terms "binding amount (mmol/g)" and "introduction rate (mol%)" mean the amount and proportion of the modifying groups introduced into (bound to) the anionic groups in the modified cellulose fibers (I). The binding amount and the introduction rate of the modifying groups in the modified cellulose fibers (I) may be calculated by methods as described in Examples below, e.g., when the anionic groups are carboxy groups.

The content of the modified cellulose B in the copper fine particle dispersion of the present invention is 2,500 ppm by mass or less, preferably 2,000 ppm by mass or less, more preferably 1,500 ppm by mass or less, even more preferably 1,000 ppm by mass or less, and still more preferably 700 ppm by mass or less from the viewpoint of increasing the bonding strength of the bonded body obtained from the copper fine particle dispersion. Furthermore, the content of the modified cellulose B is preferably 1 ppm by mass or more, more preferably 10 ppm by mass or more, even more preferably 50 ppm by mass or more, still more preferably 100 ppm by mass or more, and yet more preferably 150 ppm by mass or more from the viewpoint of improving the printing dimensional properties of the copper fine particle dispersion. More specifically, the content of the modified cellulose B is preferably 1 ppm by mass or more and 2,500 ppm by mass or less, more preferably 10 ppm by mass or more and 2,000 ppm by mass or less, even more preferably 10 ppm by mass or more and 1,500 ppm by mass or less, still more preferably 10 ppm by mass or more and 1,000 ppm by mass or less, yet more preferably 10 ppm by mass or more and 700 ppm by mass or less, much more preferably 50 ppm by mass or more and 700 ppm by mass or less, further preferably 100 ppm by mass or more and 700 ppm by mass or less, and even further preferably 150 ppm by mass or more and 700 ppm by mass or less from the viewpoint of achieving both excellent printing dimensional properties and high bonding strength. In the present invention, the term "ppm by mass" means parts per million by mass.

In the present invention, when the modified cellulose B includes one or more types of the modified cellulose fibers (I) selected from the group consisting of the modified cellulose fibers (BI) having the modifying groups bound via ionic bonds to anionic groups of the anion-modified cellulose fibers and the modified cellulose fibers (BII) having the modifying groups introduced by amidation of carboxy groups that are anionic groups of the anion-modified cellulose fibers, no matter how small the content of the modified cellulose B is, as described above, the copper nanoparticles A and the ionic binding sites or amide binding sites of the modified cellulose fibers (I) specifically interact with each other to form a physical network, thereby imparting sufficient thixotropy to the copper fine particle dispersion containing the copper nanoparticles A. Thus, even if the content of the modified cellulose fibers (I) is small, the copper fine particle dispersion of the present invention ensures more excellent printing dimensional properties and higher bonding strength of the resulting bonded body.

The mass ratio [modified cellulose B/copper nanoparticles A] of the content of the modified cellulose B to the content of the copper nanoparticles A in the copper fine particle dispersion of the present invention is preferably 0.00001 or more, more preferably 0.00002 or more, even more preferably 0.0001 or more, still more preferably 0.0002 or more, and yet more preferably 0.0003 or more from the viewpoint of improving the printing dimensional properties of the copper fine particle dispersion. Furthermore, the mass ratio of the content of the modified cellulose B to the content of the copper nanoparticles A is preferably 0.01 or less, more preferably 0.005 or less, even more preferably 0.001 or less, still more preferably 0.0006 or less, yet more preferably 0.00055 or less, and much more preferably 0.0004 or less from the viewpoint of providing the bonded body with bonding strength.

<Dispersion medium C>

The copper fine particle dispersion of the present invention contains a dispersion medium C.

The dispersion medium C preferably contains at least one selected from the group consisting of (poly)alkylene glycol, (poly)alkylene glycol derivative, terpene alcohol, glycerin (boiling point: 290°C, molecular weight: 92), and glycerin derivative from the viewpoint of improving the dispersion stability and printing dimensional properties of the copper fine particle dispersion and increasing the bonding strength of the bonded body obtained from the copper fine particle dispersion.

In the present specification, the term "(poly)alkylene glycol" means at least one selected from the group consisting of alkylene glycol and polyalkylene glycol. The term "(poly)alkylene glycol derivative" is interpreted in the same way. Moreover, in the present specification, the term "polyalkylene glycol" means glycol in which two or more

alkylene glycol structures are linked together.

Examples of the (poly)alkylene glycol include: ethylene glycol (boiling point: 197°C, molecular weight: 62); propylene glycol (boiling point: 188°C, molecular weight: 76); diethylene glycol (boiling point: 244°C, molecular weight: 106); triethylene glycol (boiling point: 287°C, molecular weight: 150); dipropylene glycol (boiling point: 232°C, molecular weight: 134); tripropylene glycol (boiling point: 273°C, molecular weight: 192); tetrapropylene glycol (boiling point: 300°C or more, molecular weight: 250); polyethylene glycol (number average molecular weight: preferably 180 or more and 1,000 or less, more preferably 180 or more and 600 or less, and even more preferably 180 or more and 400 or less); polypropylene glycol (number average molecular weight: preferably 232 or more and 1,000 or less, more preferably 232 or more and 600 or less, and even more preferably 232 or more and 500 or less); and 2-ethyl-1,3-hexanediol (boiling point: 244°C, molecular weight: 146). Among these, the (poly)alkylene glycol is more preferably one or more selected from the group consisting of diethylene glycol, dipropylene glycol, and polyethylene glycol (number average molecular weight: preferably 180 or more and 1,000 or less, more preferably 180 or more and 600 or less, and even more preferably 180 or more and 400 or less), and is further preferably one or more selected from the group consisting of diethylene glycol and polyethylene glycol (average molecular weight: 180 or more and 400 or less).

Examples of the (poly)alkylene glycol derivative include compounds in which a terminal hydroxy group of the (poly)alkylene glycol is etherified or esterified.

Preferred examples of the compound in which hydroxy groups at both ends of the polyalkylene glycol are etherified or esterified include: diethylene glycol dimethyl ether (boiling point: 162°C, molecular weight: 134); diethylene glycol dibutyl ether (boiling point: 254°C, molecular weight: 218); triethylene glycol dimethyl ether (boiling point: 216°C, molecular weight: 178); diethylene glycol monoethyl ether acetate (boiling point: 217°C, molecular weight: 176); and diethylene glycol monobutyl ether acetate (boiling point: 247°C, molecular weight: 204).

Preferred examples of the compound in which a hydroxy group at one end of the polyalkylene glycol is etherified or esterified include: diethylene glycol monoethyl ether (boiling point: 202°C, molecular weight: 134); and diethylene glycol monobutyl ether (boiling point: 231°C, molecular weight: 162). Among these, diethylene glycol monobutyl ether is more preferred.

Preferred examples of the terpene alcohol include monoterpene alcohols, e.g., $\alpha$-terpineol (boiling point: 219°C, molecular weight: 154), linalool (boiling point: 198°C, molecular weight: 154), geraniol (boiling point: 229°C, molecular weight: 154), and citronellol (boiling point: 225°C, molecular weight: 156). Among these, $\alpha$-terpineol is more preferred.

The glycerin derivative may be any solvent that contains a structure derived from glycerin. Examples of the glycerin derivative include ether derivatives of glycerin, ester derivatives of glycerin, polyglycerin, and alkylene oxide adducts of glycerin (e.g., ethylene oxide adducts and propylene oxide adducts). Preferred examples of the polyglycerin include diglycerin and triglycerin. Preferred examples of commercially available polyglycerin include Polyglycerin #310, Polyglycerin #500, and Polyglycerin #750, which are manufactured by Sakamoto Yakuhin Kogyo Co., Ltd. Preferred examples of the ether derivatives of glycerin include 3-(2-ethylhexyloxy)-1,2-propanediol (boiling point: 325°C, molecular weight: 204). Preferred examples of the ester derivatives of glycerin include glyceryl tributyrate (boiling point: 305°C, molecular weight: 302).

From the viewpoint of improving the dispersion stability and printing dimensional properties of the copper fine particle dispersion and increasing the bonding strength of the bonded body obtained from the copper fine particle dispersion, the dispersion medium C preferably contains at least one selected from the group consisting of the (poly)alkylene glycol, the (poly)alkylene glycol derivative, and the terpene alcohol, more preferably contains at least one selected from the group consisting of diethylene glycol, dipropylene glycol, polyethylene glycol (number average molecular weight: preferably 180 or more and 1,000 or less, more preferably 180 or more and 600 or less, and even more preferably 180 or more and 400 or less), $\alpha$-terpineol, and diethylene glycol monobutyl ether, and even more preferably contains at least one selected from the group consisting of diethylene glycol, polyethylene glycol (number average molecular weight: 180 or more and 400 or less), $\alpha$-terpineol, and diethylene glycol monobutyl ether.

The boiling point of the dispersion medium C at 1 atm is preferably 180°C or more, more preferably 200°C or more, even more preferably 210°C or more, and still more preferably 215°C or more, and is also preferably 400°C or less, more preferably 360°C or less, even more preferably 330°C or less, and still more preferably 300°C or less from the viewpoint of increasing the bonding strength of the bonded body obtained from the copper fine particle dispersion. When two or more dispersion media are used in combination, the boiling point of the dispersion medium C is a weighted average value of the boiling points of these dispersion media that are weighted to reflect their respective contents (% by mass).

The molecular weight of the dispersion medium C is preferably 60 or more, more preferably 100 or more, even more preferably 130 or more, and still more preferably 150 or more, and is also preferably 600 or less, more preferably 450 or less, even more preferably 400 or less, still more preferably 350 or less, and yet more preferably 300 or less from the viewpoint of increasing the bonding strength of the bonded body obtained from the copper fine particle dispersion. When two or more dispersion media are used in combination, the molecular weight of the dispersion medium C is a weighted average value of the molecular weights of these dispersion media that are weighted to reflect their respective contents (% by mass).

In particular, the dispersion medium C preferably has a boiling point of 180°C or more and a molecular weight of 600 or less from the viewpoint of increasing the bonding strength of the bonded body obtained from the copper fine particle dispersion.

The total content of the (poly)alkylene glycol, the (poly)alkylene glycol derivative, the terpene alcohol, the glycerin, and the glycerin derivative (all of which are also collectively referred to as a "dispersion medium C1" below) in the dispersion medium C is preferably 50% by mass or more, more preferably 70% by mass or more, even more preferably 80% by mass or more, still more preferably 90% by mass or more, yet more preferably 95% by mass or more, much more preferably 98% by mass or more, further preferably 99% by mass or more, even further preferably 99.9% by mass or more, and still further preferably substantially 100% by mass from the viewpoint of increasing the bonding strength of the bonded body obtained from the copper fine particle dispersion. In the present specification, the term "substantially 100% by mass" means that the dispersion medium may contain unintended components. The unintended components may include, e.g., any dispersion medium C that is other than the dispersion medium C1 and is contained in the dispersion medium C1.

The total content of the (poly)alkylene glycol, the (poly)alkylene glycol derivative, and the terpene alcohol (all of which are also collectively referred to as a "dispersion medium C2" below) in the dispersion medium C is preferably 50% by mass or more, more preferably 70% by mass or more, even more preferably 80% by mass or more, still more preferably 90% by mass or more, yet more preferably 95% by mass or more, much more preferably 98% by mass or more, further preferably 99% by mass or more, even further preferably 99.9% by mass or more, and still further preferably substantially 100% by mass from the viewpoint of increasing the bonding strength of the bonded body obtained from the copper fine particle dispersion. In the present specification, the term "substantially 100% by mass" means that the dispersion medium may contain unintended components. The unintended components may include, e.g., any dispersion medium C that is other than the dispersion medium C2 and is contained in the dispersion medium C2.

The total content of diethylene glycol, polyethylene glycol (number average molecular weight: 180 or more and 400 or less), $\alpha$-terpineol, and diethylene glycol monobutyl ether (all of which are also collectively referred to as a "dispersion medium C3" below) in the dispersion medium C is preferably 50% by mass or more, more preferably 70% by mass or more, even more preferably 80% by mass or more, still more preferably 90% by mass or more, yet more preferably 95% by mass or more, much more preferably 98% by mass or more, further preferably 99% by mass or more, even further preferably 99.9% by mass or more, and still further preferably substantially 100% by mass from the viewpoint of increasing the bonding strength of the bonded body obtained from the copper fine particle dispersion. In the present specification, the term "substantially 100% by mass" means that the dispersion medium may contain unintended components. The unintended components may include, e.g., any dispersion medium C that is other than the dispersion medium C3 and is contained in the dispersion medium C3.

The content of the dispersion medium C in the copper fine particle dispersion of the present invention is preferably 4% by mass or more, more preferably 5% by mass or more, and even more preferably 6% by mass or more from the viewpoint of improving the dispersion stability of the copper fine particle dispersion and increasing the bonding strength of the bonded body obtained from the copper fine particle dispersion. Furthermore, the content of the dispersion medium C is preferably 60% by mass or less, more preferably 40% by mass or less, even more preferably 20% by mass or less, still more preferably 15% by mass or less, and yet more preferably 10% by mass or less from the viewpoint of improving the printing dimensional properties of the copper fine particle dispersion and increasing the bonding strength of the bonded body obtained from the copper fine particle dispersion.

The mass ratio [modified cellulose B/dispersion medium C] of the content of the modified cellulose B to the content of the dispersion medium C in the copper fine particle dispersion of the present invention is preferably 0.0001 or more, more preferably 0.002 or more, even more preferably 0.005 or more, and still more preferably 0.007 or more from the viewpoint of improving the printing dimensional properties of the copper fine particle dispersion.

The mass ratio [modified cellulose B/dispersion medium C] is also preferably 0.1 or less, more preferably 0.05 or less, even more preferably 0.04 or less, still more preferably 0.03 or less, yet more preferably 0.02 or less, much more preferably 0.01 or less, further preferably 0.008 or less, even further preferably 0.006 or less, and still further preferably 0.004 or less from the viewpoint of increasing the bonding strength of the bonded body obtained from the copper fine particle dispersion.

The mass ratio [modified cellulose B/dispersion medium C] is preferably 0.0001 or more and 0.1 or less, more preferably 0.002 or more and 0.1 or less, even more preferably 0.002 or more and 0.05 or less, still more preferably 0.002 or more and 0.04 or less, yet more preferably 0.002 or more and 0.03 or less, much more preferably 0.002 or more and 0.02 or less, further preferably 0.002 or more and 0.01 or less, even further preferably 0.002 or more and 0.008 or less, still further preferably 0.002 or more and 0.006 or less, and yet further preferably 0.002 or more and 0.004 or less from the viewpoint of achieving both excellent printing dimensional properties and high bonding strength.

The content of water in the copper fine particle dispersion of the present invention is preferably 5% by mass or less, more preferably 1% by mass or less, even more preferably 0.5% by mass or less, still more preferably 0.1% by mass or less, and yet more preferably 0.01% by mass or less from the viewpoint of reducing the oxidation of copper, improving the dispersion stability, storage stability, and printing dimensional properties of the copper fine particle dispersion, and

increasing the bonding strength of the bonded body obtained from the copper fine particle dispersion.

<Copper microparticles>

The copper fine particle dispersion of the present invention may further contain copper microparticles from the viewpoint of increasing the bonding strength and 250°C heat resistance of the bonded body obtained from the copper fine particle dispersion.

The content of copper in the copper microparticles is preferably 95% by mass or more, more preferably 98% by mass or more, even more preferably 99% by mass or more, and still more preferably substantially 100% by mass from the viewpoint of increasing the bonding strength and 250°C heat resistance of the bonded body obtained from the copper fine particle dispersion.

In the present specification, the term "substantially 100% by mass" means that the copper microparticles may contain unintended components. The unintended components may include, e.g., unavoidable impurities.

The average particle size of the copper microparticles is preferably more than 0.35 pm, more preferably 0.5 pm or more, even more preferably 0.6 μm or more, still more preferably 0.7 pm or more, and is also preferably 10 pm or less, more preferably 8 pm or less, even more preferably 7 pm or less, and still more preferably 6 pm or less from the viewpoint of increasing the bonding strength and 250°C heat resistance of the bonded body obtained from the copper fine particle dispersion.

The average particle size of the copper microparticles may be measured by a method as described in Examples below.

When the copper fine particle dispersion of the present invention contains the copper microparticles, the content of the copper microparticles in the copper fine particle dispersion is preferably 5% by mass or more, more preferably 15% by mass or more, even more preferably 20% by mass or more, still more preferably 25% by mass or more, yet more preferably 30% by mass or more, and much more preferably 35% by mass or more, and is also preferably 65% by mass or less, more preferably 55% by mass or less, and even more preferably 45% by mass or less from the viewpoint of improving the dispersion stability, storage stability, and printing dimensional properties of the copper fine particle dispersion and increasing the bonding strength and 250°C heat resistance of the bonded body obtained from the copper fine particle dispersion.

When the copper fine particle dispersion of the present invention contains the copper microparticles, the mass ratio [copper nanoparticlesAl(oopper nanoparticles A + copper microparticles)] of the content of the copper nanoparticles A to the total content of the copper nanoparticles A and the copper microparticles in the copper fine particle dispersion is preferably 0.3 or more, more preferably 0.4 or more, and even more preferably 0.5 or more, and is also preferably less than 1.0, more preferably 0.9 or less, even more preferably 0.8 or less, still more preferably 0.75 or less, and yet more preferably 0.7 or less from the viewpoint of improving the dispersion stability, storage stability, and printing dimensional properties of the copper fine particle dispersion and increasing the bonding strength and 250°C heat resistance of the bonded body obtained from the copper fine particle dispersion.

[Composition of copper fine particle dispersion]

In the copper fine particle dispersion of the present invention, from the viewpoint of improving the dispersion stability, storage stability, and printing dimensional properties of the copper fine particle dispersion and increasing the bonding strength and 250°C heat resistance of the bonded body obtained from the copper fine particle dispersion, it is preferable that the content of the copper nanoparticles A is preferably 30% by mass or more and 95% by mass or less, the content of the dispersant D is preferably 0.05% by mass or more and 10% by mass or less, the content of the modified cellulose B is preferably 1 ppm by mass or more and 2,500 ppm by mass or less, the content of the dispersion medium C is preferably 4% by mass or more and 60% by mass or less, and the content of the copper microparticles is preferably 0% by mass or more and 65% by mass or less.

In the copper fine particle dispersion of the present invention, from the viewpoint of improving the dispersion stability, storage stability, and printing dimensional properties of the copper fine particle dispersion and increasing the bonding strength and 250°C heat resistance of the bonded body obtained from the copper fine particle dispersion, it is more preferable that the content of the copper nanoparticles A is preferably 50% by mass or more and 95% by mass or less, the content of the dispersant D is preferably 0.1% by mass or more and 3% by mass or less, the content of the modified cellulose B is preferably 10 ppm by mass or more and 700 ppm by mass or less, the content of the dispersion medium C is preferably 4% by mass or more and 10% by mass or less, and the content of the copper microparticles is preferably 0% by mass or more and 45% by mass or less.

The copper fine particle dispersion of the present invention may contain various additives as additional components other than the above components to the extent that they do not interfere with the effects of the present invention. Examples of the additives include metal particles other than the copper nanoparticles A and the copper

microparticles, a sintering accelerator such as glass frit, an antioxidant, a viscosity modifier, a pH adjuster, a buffer, an antifoaming agent, a leveling agent, and a volatilization inhibitor. Examples of the metal particles other than the copper nanoparticles A and the copper microparticles include metal particles of, e.g., zinc, nickel, silver, gold, palladium, and platinum.

The content of the additives in the copper fine particle dispersion of the present invention is preferably 1% by mass or less.

(Surfactant)

The copper fine particle dispersion of the present invention may further contain a surfactant. The surfactant that also functions as a leveling agent is preferred. The surfactant may be, e.g., a nonionic surfactant, an anionic surfactant, or an amphoteric surfactant, and is preferably a nonionic surfactant.

The surfactant may be used alone or in combination of two or more types.

Examples of the nonionic surfactant include an acetylene-based surfactant, a polyoxyalkylene alkyl ether surfactant, a polyhydric alcohol surfactant, a fatty acid alkanolamide, a silicone-based surfactant, and a fluorine-based surfactant.

Among these, the acetylene-based surfactant is preferred.

Preferred examples of the acetylene-based surfactant include 2,4,7,9-tetramethyl-5-decyne-4,7-diol, 2,5,8,11-tetramethyl-6-dodecyne-5,8-diol, 3,6-dimethyl-4-octyne-3,6-diol, 3,5-dimethyl-1-hexyne-3-ol, 2,4-dimethyl-5-hexyne-3-ol, and ethylene oxide (EO) adducts thereof Among these, the acetylene-based surfactant is more preferably one or more selected from the group consisting of 2,4,7,9-tetramethyl-5-decyne-4,7-diol and the EO adduct of 2,4,7,9-tetramethyl-5-decyne-4,7-diol.

The average number of moles of ethylene oxide added (also referred to as the "average number of moles of EO added" below) in the acetylene-based surfactant is preferably 1 mole or more, and is also preferably 35 moles or less, more preferably 30 moles or less, even more preferably 25 moles or less, still more preferably 20 moles or less, yet more preferably 15 moles or less, and much more preferably 10 moles or less.

The HLB value of the acetylene-based surfactant is preferably 1 or more, more preferably 2 or more, and even more preferably 3 or more, and is also preferably 18 or less, more preferably 17 or less, and even more preferably 15 or less.

In the present specification, the HLB value indicates the affinity of the surfactant for water and oil as a hydrophile-lipophile balance, and can be calculated by the Griffin's method using the following formula. The HLB value can also be referred to the catalog values of products.

HLB value = 20 × [(sum of formula weights of hydrophilic groups contained in surfactant)/(molecular weight of surfactant)

Examples of the hydrophilic group in the surfactant include a hydroxy group and an ethyleneoxy group.

Commercially available products of the acetylene-based surfactant include, e.g., SURFYNOL 104 (2,4,7,9-tetramethyl-5-decyne-4,7-diol), SURFYNOL 420 (EO adduct of 2,4,7,9-tetramethyl-5-decyne-4,7-diol (average number of moles of EO added: 1.3), HLB value: 4 (catalog value)), SURFYNOL 440 (EO adduct of 2,4,7,9-tetramethyl-5-decyne-4,7-diol (average number of moles of EO added: 3.5), HLB value: 8 (catalog value)), SURFYNOL 465 (EO adduct of 2,4,7,9-tetramethyl-5-decyne-4,7-diol (average number of moles of EO added: 10), HLB value: 13 (catalog value)), and SURFYNOL 485 (EO adduct of 2,4,7,9-tetramethyl-5-decyne-4,7-diol (average number of moles of EO added: 30), HLB value: 17 (catalog value)). All of these products are manufactured by Nissin Chemical Industry Co., Ltd.

[Production of copper fine particle dispersion]

The copper fine particle dispersion of the present invention may be produced by various methods: e.g., (i) mixing the copper nanoparticles A, which have been previously prepared by a known method, with the dispersion medium C and the modified cellulose B, and optionally the dispersant D, the copper microparticles, and various additives; or (ii) mixing a copper raw material compound, a reducing agent, and the dispersant D, and optionally a solvent for dispersing the copper raw material compound and the reducing agent, reducing the copper raw material compound to obtain a dispersion of the copper nanoparticles A, and then adding the dispersion medium C and the modified cellulose B, and optionally the copper microparticles and various additives, to the dispersion and mixing them together. In particular, from the viewpoint of improving the dispersion stability of the copper fine particle dispersion and increasing the bonding strength and 250°C heat resistance of the bonded body obtained from the copper fine particle dispersion, the copper fine particle dispersion is preferably produced by preparing a dry powder of the copper nanoparticles A containing the dispersant D (also referred to

as a "copper nanoparticle dry powder" below), and then adding the dispersion medium C and the modified cellulose B, and optionally the copper microparticles and various additives, to the copper nanoparticle dry powder and mixing them together.

The copper nanoparticle dry powder is preferably prepared in the following manner. The copper raw material compound, the reducing agent, and the dispersant D are mixed so that the copper raw material compound is reduced with the reducing agent to obtain a dispersion of the copper nanoparticles A that are dispersed with the dispersant D. Then, the dispersion of the copper nanoparticles A is dried by, e.g., freeze-drying.

Moreover, it is preferable that the modified cellulose B is dispersed in the dispersion medium C in advance, and then added as a dispersion.

The copper raw material compound can be any compound containing copper.

Preferred examples of the copper raw material compound include copper sulfate, copper nitrate, cupric oxide, cuprous oxide, copper formate, copper acetate, and copper oxalate. The copper raw material compound may be used alone or in combination of two or more types.

The reducing agent can be any compound capable of reducing the copper raw material compound.

Preferred examples of the reducing agent include: hydrazine compounds, e.g., hydrazine, hydrazine hydrochloride, hydrazine sulfate, and hydrazine hydrate; boron compounds, e.g., sodium borohydride; and inorganic acid salts, e.g., sodium sulfite, sodium hydrogen sulfite, sodium thiosulfate, sodium nitrite, sodium hyponitrite, phosphorous acid, sodium phosphite, hypophosphorous acid, and sodium hypophosphite.

The reducing agent may be used alone or in combination of two or more types.

Preferred examples of the solvent for dispersing the copper raw material compound and the reducing agent include water, methanol, ethanol, propanol, butanol, ethylene glycol, propylene glycol, diethylene glycol, and dipropylene glycol.

The temperature of the reduction reaction is preferably 5°C or more, more preferably 10°C or more, even more preferably 20°C or more, and still more preferably 30°C or more from the viewpoint of making the particle size of the copper nanoparticles A small and uniform. Furthermore, the temperature of the reduction reaction is preferably 100°C or less, more preferably 80°C or less, even more preferably 60°C or less, and still more preferably 50°C or less from the viewpoint of stably producing the copper nanoparticles. The reduction reaction may be performed either in an air atmosphere or in an inert gas atmosphere, e.g., nitrogen gas.

In the production of the copper fine particle dispersion, the dispersion of the copper nanoparticles A may be purified before freeze-drying in order to remove impurities, including an unreacted reducing agent and an excess dispersant D that does not contribute to dispersing the copper nanoparticles A.

The purification method of the dispersion of the copper nanoparticles A is not particularly limited and may include, e.g., a membrane treatment such as dialysis or ultrafiltration and a centrifugation treatment. Among these, the membrane treatment is preferred, and dialysis is more preferred from the viewpoint of efficient removal of impurities. The material of a dialysis membrane used for the dialysis is preferably regenerated cellulose.

The molecular weight cut-off of the dialysis membrane is preferably 1,000 or more, more preferably 5,000 or more, and even more preferably 10,000 or more, and is also preferably 100,000 or less, and more preferably 70,000 or less from the viewpoint of efficient removal of impurities.

The production of the copper fine particle dispersion of the present invention may further include adding the above various additives as needed and filtering the mixture through, e.g., a filter.

The copper fine particle dispersion of the present invention can be used to form conductive members of various electronic and electrical devices because the bonded body obtained from the copper fine particle dispersion is superior in bonding strength and 250°C heat resistance. For example, the conductive members are preferably used for the following applications: bonding materials such as solder; antennas such as RFID (radio frequency identifier) tags; capacitors such as MLCC (multilayer ceramic capacitor); electronic paper; image displays such as liquid crystal displays and organic EL displays; organic EL elements; organic transistors; wiring boards such as printed wiring boards and flexible wiring boards; organic solar cells; and sensors such as flexible sensors. Among these, the copper fine particle dispersion of the present invention is preferably used for bonding of multiple metal members, and more preferably used as a bonding material paste from the viewpoint of increasing the bonding strength and 250°C heat resistance of the bonded body obtained from the copper microparticle dispersion.

[Production method of bonded body]

A method for producing a bonded body of the present invention includes heating multiple metal members with a copper fine particle dispersion interposed between the adjacent metal members. The copper fine particle dispersion is the copper fine particle dispersion of the present invention.

The copper fine particle dispersion of the present invention may be used to bond multiple metal members and is suitable for the production method of the bonded body that includes heating multiple metal members with the copper fine

particle dispersion interposed between the adjacent metal members.

The temperature of the heat treatment in the heating step is preferably 100°C or more, more preferably 150°C or more, and even more preferably 200°C or more, and is also preferably 350°C or less, more preferably 300°C or less, and even more preferably 260°C or less from the viewpoint of the bonding strength.

The heat treatment may be performed either under no pressure or under pressure, and is preferably performed under pressure from the viewpoint of the bonding strength. The pressure of the heat treatment in the heating step is preferably 5 MPa or more, more preferably 8 MPa or more, even more preferably 10 MPa or more, and still more preferably 15 MPa or more from the viewpoint of increasing the bonding strength. Furthermore, the pressure of the heat treatment is preferably 50 MPa or less, more preferably 30 MPa or less, and even more preferably 20 MPa or less from the viewpoint of productivity.

The heat treatment time in the heating step can be appropriately adjusted depending on the temperature and pressure of the heat treatment.

The atmosphere in the heating step may be an air atmosphere, an inert gas atmosphere (e.g., nitrogen gas), or a reducing gas atmosphere (e.g., hydrogen gas), and is more preferably a nitrogen gas atmosphere from the viewpoint of preventing copper oxidation and ensuring safety.

Preferred examples of the metal members to be bonded in the present invention include: metal-based substrates or metal substrates, e.g., a gold substrate, a gold-plated substrate, a silver substrate, a silver-plated metal substrate, a copper substrate, a palladium substrate, a palladium-plated metal substrate, a platinum substrate, a platinum-plated metal substrate, an aluminum substrate, a nickel substrate, a nickel-plated metal substrate, a tin substrate, and a tin-plated metal substrate; and metal portions, e.g., electrodes of an electrically insulating substrate. The multiple metal members used in the present invention may be of the same type or different types.

The bonding of the metal members in the present invention may be applied to, e.g., bonding between a circuit board and chip components such as a capacitor and a resistor, bonding between a lead frame or a circuit board and semiconductor chips such as a memory, a diode, a transistor, IC, and CPU, or bonding between a semiconductor chip with high heat generation and a cooling plate.

Examples of the method for applying the copper fine particle dispersion to the metal members include: various coating methods, e.g., slot die coating, dip coating, spray coating, spin coating, doctor blading, knife edge coating, and bar coating; and various pattern printing methods, e.g., stencil printing, screen printing, flexographic printing, gravure printing, offset printing, dispenser printing, and inkjet printing. Among these, the stencil printing is preferred.

The amount of the copper fine particle dispersion applied to the metal members can be appropriately adjusted depending on the size and type of the metal members to be bonded.

The bonding strength of the bonded body is preferably 20 MPa or more. The bonding strength may be measured by a method as described in Examples below.

Concerning the above embodiments, the present invention further discloses the following aspects.

<1> A copper fine particle dispersion containing copper nanoparticles A, modified cellulose B, and a dispersion medium C,

wherein an average particle size of the copper nanoparticles A is 50 nm or more and 350 nm or less,
a content of the modified cellulose B in the copper fine particle dispersion is 2,500 ppm by mass or less,
the modified cellulose B is in the form of anion-modified cellulose fibers with modifying groups, and
the modifying groups include one or more selected from the group consisting of a hydrocarbon group (a) and a polymer group (b).

<2> The copper fine particle dispersion according to <1>, wherein the average particle size of the copper nanoparticles A is preferably 100 nm or more, more preferably 105 nm or more, even more preferably 110 nm or more, still more preferably 115 nm or more, and yet more preferably 120 nm or more, and is also preferably 270 nm or less, more preferably 250 nm or less, even more preferably 240 nm or less, still more preferably 230 nm or less, and yet more preferably 220 nm or less.

<3> The copper fine particle dispersion according to <1> or <2>, wherein the copper nanoparticles A are dispersed with a dispersant D.

<4> The copper fine particle dispersion according to <3>, wherein the dispersant D is one or more selected from the group consisting of a low molecular weight dispersant with a carboxy group and a polymer dispersant with a hydrophilic group.

<5> The copper fine particle dispersion according to <4>, wherein the low molecular weight dispersant is one or more selected from the group consisting of aliphatic carboxylic acid having 1 to 24 carbon atoms and aliphatic hydroxycarboxylic acid having 2 to 34 carbon atoms.

<6> The copper fine particle dispersion according to <4>, wherein the polymer dispersant is a vinyl polymer P

containing a constitutional unit derived from a monomer (p-1) having a carboxy group and a constitutional unit derived from a monomer (p-2) having a polyalkylene glycol segment.

<7> The copper fine particle dispersion according to <6>, wherein the monomer (p-1) is preferably at least one selected from the group consisting of (meth)acrylic acid and maleic acid, more preferably (meth)acrylic acid, and even more preferably methacrylic acid.

<8> The copper fine particle dispersion according to <6> or <7>, wherein the monomer (p-2) is preferably at least one selected from the group consisting of polyalkylene glycol (meth)acrylate and alkoxy polyalkylene glycol (meth) acrylate, and more preferably alkoxy polyalkylene glycol (meth)acrylate.

<9> The copper fine particle dispersion according to any one of <6> to <8>, wherein a content of the constitutional unit derived from the monomer (p-1) in all the constitutional units of the vinyl polymer P is preferably 3% by mass or more, and more preferably 5% by mass or more, and is also preferably 35% by mass or less, more preferably 25% by mass or less, and even more preferably 18% by mass or less.

<10> The copper fine particle dispersion according to any one of <6> to <9>, wherein a content of the constitutional unit derived from the monomer (p-2) in all the constitutional units of the vinyl polymer P is preferably 55% by mass or more, more preferably 60% by mass or more, and even more preferably 65% by mass or more, and is also preferably 97% by mass or less, and more preferably 95% by mass or less.

<11> The copper fine particle dispersion according to any one of <6> to <10>, wherein an acid value of the vinyl polymer P is preferably 20 mgKOH/g or more, more preferably 25 mgKOH/g or more, even more preferably 30 mgKOH/g or more, still more preferably 35 mgKOH/g or more, and yet more preferably 40 mgKOH/g or more, and is also preferably 250 mgKOH/g or less, more preferably 200 mgKOH/g or less, even more preferably 150 mgKOH/g or less, and still more preferably 110 mgKOH/g or less.

<12> The copper fine particle dispersion according to any one of <1> to <11>, wherein a content of the copper nanoparticles A in the copper fine particle dispersion is preferably 30% by mass or more, more preferably 40% by mass or more, even more preferably 50% by mass or more, and still more preferably 52% by mass or more, and is also preferably 95% by mass or less, more preferably 94% by mass or less, and even more preferably 93% by mass or less.

<13> The copper fine particle dispersion according to any one of <3> to <12>, wherein a content of the dispersant D in the copper fine particle dispersion is preferably 0.05% by mass or more, more preferably 0.1% by mass or more, even more preferably 0.3% by mass or more, still more preferably 0.4% by mass or more, yet more preferably 0.5% by mass or more, and much more preferably 0.7% by mass or more, and is also preferably 10% by mass or less, more preferably 8% by mass or less, even more preferably 5% by mass or less, still more preferably 3% by mass or less, yet more preferably 2% by mass or less, and much more preferably 1.5% by mass or less.

<14> The copper fine particle dispersion according to any one of <3> to <13>, wherein a mass ratio [dispersant D/(copper nanoparticles A + dispersant D)] of the content of the dispersant D to the total content of the copper nanoparticles A and the dispersant D in the copper fine particle dispersion is preferably 0.003 or more, more preferably 0.005 or more, even more preferably 0.006 or more, still more preferably 0.008 or more, and yet more preferably 0.010 or more, and is also preferably 0.025 or less, more preferably 0.020 or less, even more preferably 0.018 or less, still more preferably 0.016 or less, and yet more preferably 0.012 or less.

<15> The copper fine particle dispersion according to any one of <1> to <14>, wherein the modified cellulose B preferably includes one or more types of modified cellulose fibers (I) selected from the group consisting of modified cellulose fibers (BI) having the modifying groups bound via ionic bonds to anionic groups of the anion-modified cellulose fibers and modified cellulose fibers (BII) having the modifying groups introduced by amidation of carboxy groups that are anionic groups of the anion-modified cellulose fibers, and more preferably includes the modified cellulose fibers (BII).

<16> The copper fine particle dispersion according to <15>, wherein the anion-modified cellulose fibers are modified cellulose fibers in which the carbon atoms at the C6 positions of the glucose units in cellulose fibers constitute carboxy groups.

<17> The copper fine particle dispersion according to <15> or <16>, wherein the modifying groups of the modified cellulose fibers (BI) preferably include the polymer group (b).

<18> The copper fine particle dispersion according to any one of <15> to <17>, wherein the modified cellulose fibers (BI) have a structure represented by the following formula (2):

[Chemical Formula 4]

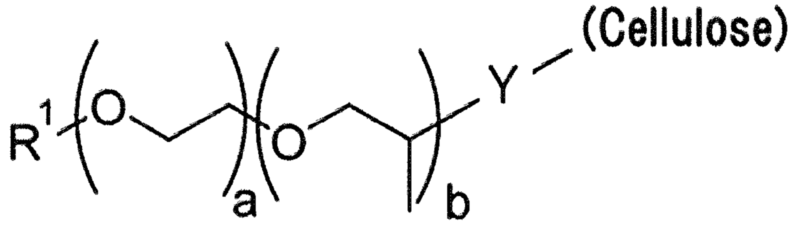

(2)

in the formula (2), Y represents an ionic bond, $R^1$ represents a hydrogen atom or a hydrocarbon group having 1 to 6 carbon atoms, EO-derived units and PO-derived units are present in a random or block form, a represents a positive number indicating an average number of moles of EO added, and b represents a positive number indicating an average number of moles of PO added.

<19> The copper fine particle dispersion according to any one of <15> to <18>, wherein the modified cellulose fibers (BII) are preferably modified cellulose fibers in which the carbon atoms at the C6 positions of the glucose units in the anion-modified cellulose fibers constitute amide bonds and the modifying groups are bound via the amide bonds.

<20> The copper fine particle dispersion according to any one of <15> to <18>, wherein the modified cellulose fibers (BII) are preferably produced through an amidation reaction between a modifying compound and carboxy-modified cellulose fibers in which hydroxymethyl groups ($-CH_2OH$) at the C6 positions of the glucose units in cellulose fibers have been selectively converted to carboxy groups.

<21> The copper fine particle dispersion according to any one of <15> to <20>, wherein the modifying groups of the modified cellulose fibers (BII) preferably include the polymer group (b).

<22> The copper fine particle dispersion according to any one of <15> to <21>, wherein the modified cellulose fibers (BII) have a structure represented by the following formula (3):

[Chemical Formula 5]

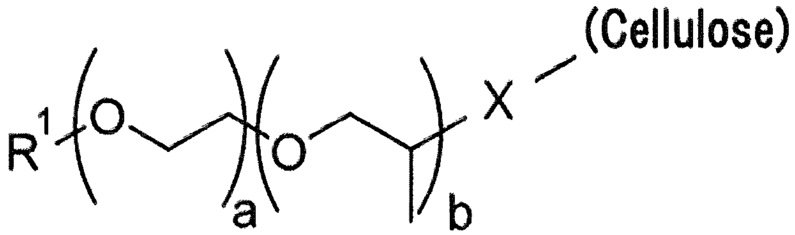

(3)

in the formula (3), X represents an amide bond, $R^1$ represents a hydrogen atom or a hydrocarbon group having 1 to 6 carbon atoms, EO-derived units and PO-derived units are present in a random or block form, a represents a positive number indicating an average number of moles of EO added, and b represents a positive number indicating an average number of moles of PO added.

<23> The copper fine particle dispersion according to any one of <1> to <22>, wherein the modified cellulose B preferably includes one or more types of modified cellulose fibers (I) selected from the group consisting of modified cellulose fibers (BI) having the modifying groups bound via ionic bonds to anionic groups of the anion-modified cellulose fibers and modified cellulose fibers (BII) having the modifying groups introduced by amidation of carboxy groups that are anionic groups of the anion-modified cellulose fibers, more preferably includes the modified cellulose fibers (BII), and even more preferably includes modified cellulose fibers in which the carbon atoms at the C6 positions of the glucose units in the anion-modified cellulose fibers constitute amide bonds and the modifying groups are bound via the amide bonds.

<24> The copper fine particle dispersion according to any one of <15> to <23>, wherein a degree of crystallinity of the modified cellulose fibers (I) is preferably 20% or more, more preferably 25% or more, even more preferably 30% or more, still more preferably 35% or more, and yet more preferably 40% or more, and is also preferably 90% or less, more preferably 85% or less, even more preferably 80% or less, still more preferably 75% or less, and yet more preferably 70% or less.

<25> The copper fine particle dispersion according to any one of <15> to <24>, wherein an average fiber diameter of the modified cellulose fibers (I) is preferably 1 nm or more, and more preferably 2 nm or more, and is also preferably

300 nm or less, more preferably 200 nm or less, even more preferably 100 nm or less, still more preferably 50 nm or less, yet more preferably 30 nm or less, much more preferably 20 nm or less, further preferably 15 nm or less, even further preferably 10 nm or less, and still further preferably 5 nm or less.

<26> The copper fine particle dispersion according to any one of <15> to <25>, wherein an average aspect ratio (average fiber length/average fiber diameter) of the modified cellulose fibers (I) is preferably 5 or more, more preferably 10 or more, even more preferably 30 or more, still more preferably 50 or more, yet more preferably 70 or more, much more preferably 80 or more, and further preferably 90 or more, and is also preferably 300 or less, more preferably 200 or less, even more preferably 120 or less, and still more preferably 100 or less.

<27> The copper fine particle dispersion according to any one of <1> to <26>, wherein the content of the modified cellulose B in the copper fine particle dispersion is preferably 2,000 ppm by mass or less, more preferably 1,500 ppm by mass or less, even more preferably 1,000 ppm by mass or less, and still more preferably 700 ppm by mass or less, and is also preferably 1 ppm by mass or more, more preferably 10 ppm by mass or more, even more preferably 50 ppm by mass or more, still more preferably 100 ppm by mass or more, and yet more preferably 150 ppm by mass or more.

<28> The copper fine particle dispersion according to any one of <1> to <27>, wherein the content of the modified cellulose B in the copper fine particle dispersion is preferably 1 ppm by mass or more and 2,500 ppm by mass or less, more preferably 10 ppm by mass or more and 2,000 ppm by mass or less, even more preferably 10 ppm by mass or more and 1,500 ppm by mass or less, still more preferably 10 ppm by mass or more and 1,000 ppm by mass or less, yet more preferably 10 ppm by mass or more and 700 ppm by mass or less, much more preferably 50 ppm by mass or more and 700 ppm by mass or less, further preferably 100 ppm by mass or more and 700 ppm by mass or less, and even further preferably 150 ppm by mass or more and 700 ppm by mass or less.

<29> The copper fine particle dispersion according to any one of <1> to <28>, wherein a mass ratio [modified cellulose B/copper nanoparticles A] of the content of the modified cellulose B to the content of the copper nanoparticles A in the copper fine particle dispersion is preferably 0.00001 or more, more preferably 0.00002 or more, even more preferably 0.0001 or more, still more preferably 0.0002 or more, and yet more preferably 0.0003 or more, and is also preferably 0.01 or less, more preferably 0.005 or less, even more preferably 0.001 or less, still more preferably 0.0006 or less, yet more preferably 0.00055 or less, and much more preferably 0.0004 or less.

<30> The copper fine particle dispersion according to any one of <1> or <29>, wherein the dispersion medium C contains at least one selected from the group consisting of (poly)alkylene glycol, (poly)alkylene glycol derivative, terpene alcohol, glycerin, and glycerin derivative.

<31> The copper fine particle dispersion according to any one of <1> to <30>, wherein a boiling point of the dispersion medium C at 1 atm is preferably 180°C or more, more preferably 200°C or more, even more preferably 210°C or more, and still more preferably 215°C or more, and is also preferably 400°C or less, more preferably 360°C or less, even more preferably 330°C or less, and still more preferably 300°C or less.

<32> The copper fine particle dispersion according to any one of <1> to <31>, wherein a content of the dispersion medium C in the copper fine particle dispersion is preferably 4% by mass or more, more preferably 5% by mass or more, and even more preferably 6% by mass or more, and is also preferably 60% by mass or less, more preferably 40% by mass or less, even more preferably 20% by mass or less, still more preferably 15% by mass or less, and yet more preferably 10% by mass or less.

<33> The copper fine particle dispersion according to any one of <1> to <32>, wherein a mass ratio [modified cellulose B/dispersion medium C] of the content of the modified cellulose B to the content of the dispersion medium C in the copper fine particle dispersion is preferably 0.0001 or more, more preferably 0.002 or more, even more preferably 0.005 or more, and still more preferably 0.007 or more, and is also preferably 0.1 or less, more preferably 0.05 or less, even more preferably 0.04 or less, still more preferably 0.03 or less, yet more preferably 0.02 or less, much more preferably 0.01 or less, further preferably 0.008 or less, even further preferably 0.006 or less, and still further preferably 0.004 or less.

<34> The copper fine particle dispersion according to any one of <1> to <33>, wherein the mass ratio [modified cellulose B/dispersion medium C] of the content of the modified cellulose B to the content of the dispersion medium C in the copper fine particle dispersion is preferably 0.0001 or more and 0.1 or less, more preferably 0.002 or more and 0.1 or less, even more preferably 0.002 or more and 0.05 or less, still more preferably 0.002 or more and 0.04 or less, yet more preferably 0.002 or more and 0.03 or less, much more preferably 0.002 or more and 0.02 or less, further preferably 0.002 or more and 0.01 or less, even further preferably 0.002 or more and 0.008 or less, still further preferably 0.002 or more and 0.006 or less, and yet further preferably 0.002 or more and 0.004 or less.

<35> The copper fine particle dispersion according to any one of <1> to <34>, further containing copper microparticles.

<36> The copper fine particle dispersion according to <35>, wherein an average particle size of the copper microparticles is preferably more than 0.35 pm, more preferably 0.5 pm or more, even more preferably 0.6 pm or more, and still more preferably 0.7 pm or more, and is also preferably 10 pm or less, more preferably 8 μm or less, even more preferably 7 pm or less, and still more preferably 6 pm or less.

<37> The copper fine particle dispersion according to <35> or <36>, wherein a content of the copper microparticles in the copper fine particle dispersion is preferably 5% by mass or more, more preferably 15% by mass or more, even more preferably 20% by mass or more, still more preferably 25% by mass or more, yet more preferably 30% by mass or more, and much more preferably 35% by mass or more, and is also preferably 65% by mass or less, more preferably 55% by mass or less, and even more preferably 45% by mass or less.
<38> The copper fine particle dispersion according to any one of<35> to <37>, wherein a mass ratio [copper nanoparticles A/(copper nanoparticles A + copper microparticles)] of the content of the copper nanoparticles A to the total content of the copper nanoparticles A and the copper microparticles in the copper fine particle dispersion is preferably 0.3 or more, more preferably 0.4 or more, and even more preferably 0.5 or more, and is also preferably less than 1.0, more preferably 0.9 or less, even more preferably 0.8 or less, still more preferably 0.75 or less, and yet more preferably 0.7 or less.
<39> A copper fine particle dispersion containing copper nanoparticles A, modified cellulose B, and a dispersion medium C,

wherein an average particle size of the copper nanoparticles A is 50 nm or more and 350 nm or less,
a content of the modified cellulose B in the copper fine particle dispersion is 2,500 ppm by mass or less,
the modified cellulose B is in the form of anion-modified cellulose fibers with modifying groups,
the modifying groups include one or more selected from the group consisting of a hydrocarbon group (a) and a polymer group (b),
the modified cellulose B includes one or more types of modified cellulose fibers (I) selected from the group consisting of modified cellulose fibers (BI) having the modifying groups bound via ionic bonds to anionic groups of the anion-modified cellulose fibers and modified cellulose fibers (BII) having the modifying groups introduced by amidation of carboxy groups that are anionic groups of the anion-modified cellulose fibers, and
a degree of crystallinity of the modified cellulose fibers (I) is 20% or more and 90% or less.

<40> A copper fine particle dispersion containing copper nanoparticles A, modified cellulose B, a dispersion medium C, and copper microparticles,

wherein an average particle size of the copper nanoparticles A is 50 nm or more and 350 nm or less,
a content of the modified cellulose B in the copper fine particle dispersion is 2,500 ppm by mass or less,
the modified cellulose B is in the form of anion-modified cellulose fibers with modifying groups,
the modifying groups include one or more selected from the group consisting of a hydrocarbon group (a) and a polymer group (b),
the modified cellulose B includes one or more types of modified cellulose fibers (I) selected from the group consisting of modified cellulose fibers (BI) having the modifying groups bound via ionic bonds to anionic groups of the anion-modified cellulose fibers and modified cellulose fibers (BII) having the modifying groups introduced by amidation of carboxy groups that are anionic groups of the anion-modified cellulose fibers, and
a degree of crystallinity of the modified cellulose fibers (I) is 20% or more and 90% or less, and
an average particle size of the copper microparticles is more than 0.35 pm and 10 pm or less.

<41> A copper fine particle dispersion containing copper nanoparticles A, modified cellulose B, a dispersion medium C, a dispersant D, and copper microparticles,

wherein the copper nanoparticles A are dispersed with the dispersant D,
an average particle size of the copper nanoparticles A is 50 nm or more and 350 nm or less,
a content of the modified cellulose B in the copper fine particle dispersion is 2,500 ppm by mass or less,
the modified cellulose B is in the form of anion-modified cellulose fibers with modifying groups,
the modifying groups include one or more selected from the group consisting of a hydrocarbon group (a) and a polymer group (b),
the modified cellulose B includes one or more types of modified cellulose fibers (I) selected from the group consisting of modified cellulose fibers (BI) having the modifying groups bound via ionic bonds to anionic groups of the anion-modified cellulose fibers and modified cellulose fibers (BII) having the modifying groups introduced by amidation of carboxy groups that are anionic groups of the anion-modified cellulose fibers,
a degree of crystallinity of the modified cellulose fibers (I) is 20% or more and 90% or less, and
an average particle size of the copper microparticles is more than 0.35 pm and 10 pm or less.

<42> The copper fine particle dispersion according to any one of <1> to <42>, used for bonding of multiple metal members.

<43> A method for producing a bonded body, including:
heating multiple metal members with the copper fine particle dispersion according to any one of <1> to <41> interposed between the adjacent metal members.
<44> The method according to <43>, wherein the copper fine particle dispersion is applied to the metal members by stencil printing.
<45> The method according to <43> or <44>, wherein a temperature of a heat treatment in the heating is preferably 100°C or more, more preferably 150°C or more, and even more preferably 200°C or more, and is also preferably 350°C or less, more preferably 300°C or less, and even more preferably 260°C or less.
<46> The method according to any one of <43> to <45>, wherein a pressure of the heat treatment in the heating is preferably 5 MPa or more, more preferably 8 MPa or more, even more preferably 10 MPa or more, and still more preferably 15 MPa or more, and is also preferably 50 MPa or less, more preferably 30 MPa or less, and even more preferably 20 MPa or less from the viewpoint of productivity.
<47> Use of the copper fine particle dispersion according to any one of <1> to <41> as a bonding material paste.

Examples.

Hereinafter, the present invention will be described in more detail by way of examples. However, the scope of the present invention is not limited to the following examples.
Various physical properties were measured or calculated by the following methods.
[Measurement of number average molecular weight Mn of vinyl polymer P]
The number average molecular weight Mn of the vinyl polymer P was determined by gel permeation chromatography. A measurement sample was prepared by mixing 0.1 g of a polymer with 10 mL of an eluent in a glass vial, stirring the mixture at 25°C for 10 hours with a magnetic stirrer, and filtering it through a syringe filter (DISMIC-13HP PTFE 0.2 μm, manufactured by ADVANTEC TOYO KAISHA, LTD.). The measurement conditions are as follows.

GPC apparatus: "HLC-8320GPC' manufactured by Tosoh Corporation
Column: "TSKgel SuperAWM-H, TSKgel SuperAW3000, TSKgel guardcolumn Super AW-H" manufactured by Tosoh Corporation
Eluent: solution prepared by dissolving phosphoric acid and lithium bromide in N,N-dimethylformamide at concentrations of 60 mmol/L and 50 mmol/L, respectively
Flow rate: 0.5 mL/min
Reference material: monodisperse polystyrene kit "PStQuick B (F-550, F-80, F-10, F-1, A-1000), PStQuick C (F-288, F-40, F-4, A-5000, A-500)" manufactured by Tosoh Corporation

[Measurement of acid value of vinyl polymer P]

The acid value of the vinyl polymer P was measured in accordance with JIS K 0070-1992 (potentiometric titration), except that the measurement solvent was changed from the mixed solvent of ethanol and ether specified in JIS K 0070 to a mixed solvent of acetone and toluene (acetone : toluene = 4 : 6 (volume ratio)).
[Measurement of average particle size of copper nanoparticles A and average particle size of copper microparticles]
Scanning electron microscope (SEM) images of the copper nanoparticles A and the copper microparticles were taken using a scanning electron microscope (S-4800: field-emission scanning electron microscope, manufactured by Hitachi High-Tech Corporation). The magnification was determined according to the particle size, and the SEM images were obtained in the range of 5,000X to 150,000X. Then, the SEM images were analyzed with image analysis software "ImageJ" (National Institutes of Health) to measure the particle sizes of at least 100 particles per sample. The arithmetic mean values of the measured particle sizes were calculated and defined as the average particle size of the copper nanoparticles A and the average particle size of the copper microparticles, respectively.

[Calculation of dispersant mass ratio [dispersant D/(copper nanoparticles A + dispersant D)]]

Using a simultaneous thermogravimetric and differential thermal analyzer (TG/DTA) (trade name: STA7200RV, manufactured by Hitachi High-Tech Science Corporation), 10 mg of a sample (dry powder of the copper nanoparticles A containing the dispersant D) was weighed in an aluminum pan cell and heated from 35°C to 550°C at a temperature rise rate of 10°C/min under a nitrogen flow of 50 mL/min, and a mass decrement of the sample was measured. The dispersant mass ratio [dispersant D/(copper nanoparticles A + dispersant D)] was calculated by the following formula, where the mass decrement between 35°C and 550°C represents the mass of the dispersant D and the remaining mass at 550°C

represents the mass of the copper nanoparticles A.

Dispersant mass ratio = (mass decrement between 35°C and 550°C)/(mass decrement between 35°C and 550°C + remaining mass at 550°C)

[Calculation of average fiber diameter, average fiber length, and aspect ratio (average fiber length/average fiber diameter) of modified cellulose fibers (I), anion-modified cellulose fibers, and shortened anion-modified cellulose fibers]
One of the following measurement methods (1) and (2) was selected depending on the size of the cellulose fibers to be measured.

(1) Modified cellulose fibers (I)

The cellulose fibers to be measured were mixed with deionized water or N, N-dimethylformamide (DMF) to prepare a dispersion containing 0.0001% by mass of the cellulose fibers. The dispersion was dropped onto mica and dried, which was then used as an observation sample. The fiber heights of the cellulose fibers (i.e., the difference in height between the portion with fibers and the portion without fibers) in the observation sample was measured using an atomic force microscope (AFM) (Nanoscope II tapping-mode AFM, manufactured by Digital Instruments) with a probe (PointProbe (NCH), manufactured by NANOSENSORS). With respect to the microscopic images in which the cellulose fibers were visually observed, 100 cellulose fibers were extracted from them, and the average fiber diameter was calculated based on the fiber heights of the extracted fibers. Moreover, the average fiber length was calculated based on the distance in the fiber direction. The aspect ratio (average fiber length/average fiber diameter) was calculated from the average fiber diameter and the average fiber length thus determined.

(2) Anion-modified cellulose fibers and shortened anion-modified cellulose fibers

The cellulose fibers to be measured were mixed with deionized water to prepare a dispersion containing 0.01% by mass of the cellulose fibers. The dispersion was measured using a wet dispersion type image analysis particle size distribution meter (trade name: IF-3200, manufactured by JASCO INTERNATIONAL CO., LTD) under the following conditions: front lens: 2X, telecentric zoom lens: 1X, image resolution: 0.835 pm/pixel, syringe inner diameter: 6515 μm, spacer thickness: 500 μm, image recognition mode: ghost, threshold: 8, analytical sample volume: 1 mL, and sampling: 15%. Assuming that each cellulose fiber was approximated as a rectangle having a minor axis and a major axis, the length of the minor axis would be a fiber diameter and the length of the major axis would be a fiber length. Then, 100 cellulose fibers were measured to determine their fiber diameters and fiber lengths, and the respective average values were calculated. The aspect ratio (average fiber length/average fiber diameter) was calculated from the average fiber diameter and the average fiber length thus determined.
[Measurement of anionic group (carboxy group) content of anion-modified cellulose fibers, shortened anion-modified cellulose fibers, and modified cellulose fibers (I)]
The cellulose fibers to be measured with a dry mass of 0.5 g were placed in a beaker, and deionized water or a mixed solvent with a methanol/deionized water ratio (volume ratio) of 2/1 was added to make a total of 55 mL, to which 5 mL of a 0.01 M sodium chloride aqueous solution was added to prepare a dispersion. The dispersion was stirred until the cellulose fibers were fully dispersed. Then, the pH was adjusted to 2.5 to 3 by adding 0.1 M hydrochloric acid to the dispersion. Using an automatic titrator (AUT-701, manufactured by DKK-TOA CORPORATION), a 0.05 M sodium hydroxide aqueous solution was dropped into the dispersion with a waiting time of 60 seconds, and the electrical conductivity and the pH value were measured every minute. The measurement was continued until the pH reached about 11, and an electrical conductivity curve was obtained. The titration amount of the sodium hydroxide aqueous solution was determined from the electrical conductivity curve, and the content of the anionic groups of the cellulose fibers to be measured was calculated by the following formula.

Anionic group content (mmol/g) = [titration amount of sodium hydroxide aqueous solution (mL) × concentration of sodium hydroxide aqueous solution (0.05 M)]/[mass of cellulose fibers to be measured (0.5 g)]

[Binding amount and introduction rate of modifying groups of modified cellulose fibers B (modified cellulose fibers (I))]

The binding amount of the modifying groups was determined by the following IR measurement method, and the binding amount and the introduction rate were calculated by the following formulas. Specifically, in the IR measurement, the infrared absorption spectrum of the dried modified cellulose fibers B (modified cellulose fibers (I)) was measured by the ATR method using an infrared absorption spectrometer (IR) (Nicolet 6700, manufactured by Thermo Fisher Scientific),

and the binding amount and the introduction rate of the modifying groups were calculated by the formulas A and B below. The following formulars indicate the modified cellulose fibers in which the anionic groups are carboxy groups, i.e., the carboxy-modified cellulose fibers (anion-modified cellulose fibers). The "peak intensity at 1,720 $cm^{-1}$" is a peak intensity derived from the carbonyl group. When the anionic groups are other than carboxy groups, the wave number may be appropriately changed to calculate the binding amount and the introduction rate of the modifying groups.

<Formula A>

Binding amount d of modifying groups (mmol/g) = a×(b - c)÷b

a: carboxy group content (mmol/g) of carboxy-modified cellulose fibers (anion-modified cellulose fibers)
b: peak intensity at 1,720 $cm^{-1}$ of carboxy-modified cellulose fibers (anion-modified cellulose fibers)
c: peak intensity at 1,720 $cm^{-1}$ of modified cellulose fibers B (modified cellulose fibers (I))

<Formula B>

Introduction rate e of modifying groups (mol%) = 100× d/a

[Measurement of solid content in gel or dispersion]

A halogen moisture meter (trade name: "MOC-120H" manufactured by Shimadzu Corporation) was used to measure 1 g of a sample every 30 seconds at a constant temperature of 150°C, and the solid content was defined as a value at which the mass decrement was 0.1% or less of the initial amount of the sample. If it is difficult to analyze the solid concentration by the above analysis method due to the use of a high-boiling organic solvent, a known alternative method such as a phenol-sulfuric acid method may be used.
[Degree of crystallinity of anion-modified cellulose fibers, shortened anion-modified cellulose fibers, and modified cellulose fibers (I)]
The degree of crystallinity of the anion-modified cellulose fibers, the shortened anion-modified cellulose fibers, and the modified cellulose fibers (I) was determined using an X-ray diffractometer (MiniFlex II, manufactured by Rigaku Corporation) under the following conditions.
Measurement pellet preparation conditions: a smooth pellet with a size of area 320 $mm^2$ ×thickness 1 mm was prepared by applying pressure of 10 to 20 MPa to the target cellulose fibers using a tablet molding machine.
X-ray diffraction analysis conditions: step angle 0.01°, scan speed 10°/min, measurement range: diffraction angle 2θ = 5 to 40°
X-ray source: Cu/Kα-radiation, tube voltage: 15 kV, tube current: 30 mA
Peak splitting conditions: after removing background noise, the data was fitted to the Gaussian function so that the error in the range of 2θ = 13 to 23° was within 5%.
The degree of crystallinity of the cellulose I crystal structure of the anion-modified cellulose fibers, the shortened anion-modified cellulose fibers, and the modified cellulose fibers (I) was calculated by the following formula (A) using the area of the X-ray diffraction peak obtained by the peak splitting described above.

$$\text{Degree of cellulose I crystallinity (\%)} = [Icr / (Icr + Iam)] \times 100 \quad (A)$$

In the formula, Icr represents the area of the diffraction peak of the lattice plane (002 plane) (diffraction angle 2θ = 22 to 23°) and Iam represents the area of the diffraction peak of the amorphous portion (diffraction angle 2θ= 18.5°) in the X-ray diffraction.

(Production of vinyl polymer P)

Production Example 1 (polymer P-1)

A 1000 mL four-necked round-bottom flask equipped with a thermometer, two 100 mL dropping funnels with nitrogen bypass, and a reflux device was charged with 20.0 g of ethanol (guaranteed reagent, manufactured by FUJIFILM Wako Pure Chemical Corporation), and the internal temperature of the flask was increased to 80°C in an oil bath, followed by nitrogen bubbling for 10 minutes. Next, 15.3 g of methacrylic acid (guaranteed reagent, manufactured by FUJIFILM Wako Pure Chemical Corporation), 67.5 g of methoxy polyethylene glycol (EO 23 mol) methacrylate ("PME-1000" manufactured by NOF CORPORATION), 7.2 g of methyl methacrylate (guaranteed reagent, manufactured by FUJIFILM

Wako Pure Chemical Corporation), 10.0 g of styrene (guaranteed reagent, manufactured by FUJIFILM Wako Pure Chemical Corporation), 1.0 g of 3-mercaptopropionic acid (guaranteed reagent, manufactured by FUJIFILM Wako Pure Chemical Corporation), and 28.7 g of ethanol were dissolved in a plastic beaker, and the mixture was placed in a dropping funnel (1). Separately, 51.3 g of ethanol and 1.3 g of 2,2'-azobis(2,4-dimethylvaleronitrile) (polymerization initiator, "V-65" manufactured by FUJIFILM Wako Pure Chemical Corporation) were dissolved in a plastic beaker, and the mixture was placed in a dropping funnel (2). Then, the mixture in the dropping funnel (1) and the mixture in the dropping funnel (2) were simultaneously dropped into the flask over 90 minutes. Thereafter, the internal temperature of the flask was increased to 90°C, and stirring was continued for another 1 hour to terminate the reaction. The resulting resin solution was dried in a freeze dryer (model: FDU-2110, manufactured by TOKYO RIKAKIKAI CO., LTD.) equipped with a dry chamber (model: DRC-1000, manufactured by TOKYO RIKAKIKAI CO., LTD.) under drying conditions (freezing at - 25°C for 1 hour, pressure reduction at - 10°C for 9 hours, and pressure reduction at 25°C for 5 hours; vacuum degree 5 Pa), thereby providing an absolutely dried polymer P-1 (methacrylic acid/methoxy polyethylene glycol (EO 23 mol) methacrylatelmethyl methacrylate/styrene copolymer, Mn: 9,000, acid value: 100 mgKOH/g).

Production Example 2 (polymer P-2)

An absolutely dried polymer P-2 was produced in the same manner as Production Example 1, except that the monomer composition was changed as shown in Table 1.

[TABLE 1]

| | | | Production Example | |
|---|---|---|---|---|
| | | | 1 | 2 |
| Vinyl polymer P | | | P-1 | P-2 |
| Monomer composition (parts by mass) | Monomer (p-1) | MAA | 15.3 | 7.0 |
| | Monomer (p-2) | MPEG(23)MA | 67.5 | 93.0 |
| | Monomer (p-3) | MMA | 7.2 | - |
| | | St | 10.0 | - |
| Physical properties | Number average molecular weight Mn | | 9000 | 9000 |
| | Acid value (mgKOH/g) | | 100 | 46 |

MAA: methacrylic acid (guaranteed reagent, manufactured by FUJIFILM Wako Pure Chemical Corporation)
MPEG (23) MA: methoxy polyethylene glycol (EO 23 mol) methacrylate ("PME-1000" manufactured by NOF CORPORATION)
MMA: methyl methacrylate (guaranteed reagent, manufactured by FUJIFILM Wako Pure Chemical Corporation)
St: styrene (guaranteed reagent, manufactured by FUJIFILM Wako Pure Chemical Corporation)

(Synthesis of dry powder of copper nanoparticles A)

Synthesis Example 1 (dry powder of copper nanoparticles A-1 containing polymer P-1)

A 2 L beaker was charged with 88.4 g of copper sulfate pentahydrate (guaranteed reagent, manufactured by FUJIFILM Wako Pure Chemical Corporation) as the copper raw material compound, 0.7 g of the absolutely dried polymer P-1 produced in Production Example 1 as the dispersant D, and 1,000 g of ion-exchanged water. The mixture was stirred at 40°C with a magnetic stirrer until it became visually transparent, and thus a mixed solution was prepared.

Next, 17.8 g of hydrazine monohydrate (guaranteed reagent, manufactured by FUJIFILM Wako Pure Chemical Corporation) was placed in a 50 mL dropping funnel, and then dropped into the mixed solution at 25°C over 60 minutes. Thereafter, the reaction solution was stirred for 5 hours while controlling the temperature of the reaction solution at 40°C in an oil bath, and subsequently air-cooled to obtain a reddish-brown dispersion containing dispersed copper nanoparticles A-1.

The entire amount of the dispersion thus obtained was put in a dialysis tube (trade name: SpectraPor 6, dialysis membrane: regenerated cellulose, molecular weight cut-off (MWCO) = 50K, manufactured by Repligen Corporation), and both ends of the tube were hermetically sealed with closers. This tube was immersed in 5 L of ion-exchanged water in a 5 L glass beaker and stirred for 1 hour while maintaining the water temperature at 20 to 25°C. Then, the entire amount of ion-exchanged water was repeatedly replaced every hour. Sampling was performed before each replacement of the ion-exchanged water, and dialysis was terminated when the electrical conductivity of the dispersion was 7 mS/m or less, resulting in a dispersion of the copper nanoparticles A-1. The electrical conductivity was measured after the copper concentration had been adjusted to 1% by diluting the dispersion with ion-exchanged water.

The purified dispersion of the copper nanoparticles A-1 was freeze-dried in a freeze dryer (model: FDU-2110, manufactured by TOKYO RIKAKIKAI CO., LTD.) equipped with a dry chamber (model: DRC-1000, manufactured by TOKYO RIKAKIKAI CO., LTD.), thereby providing 21.3 g of dry powder of the copper nanoparticles A-1 containing the polymer P-1. The drying conditions were as follows: the dispersion was frozen at a temperature of - 25°C for 1 hour, dried under reduced pressure at 5 Pa and at a temperature of 10°C for 9 hours, and further dried under reduced pressure at 5 Pa and at a temperature of 25°C for 5 hours. This yielded the dry powder of the copper nanoparticles A-1 containing the polymer P-1 (also referred to as a "dry powder of the copper nanoparticles A-1" below). The copper nanoparticles A-1 had an average particle size of 120 nm and a dispersant mass ratio of 0.016.

Synthesis Example 2 (dry powder of copper nanoparticles A-2 containing polymer P-2)

A dry powder of copper nanoparticles A-2 containing the polymer P-2 (also referred to as a "dry powder of the copper nanoparticles A-2" below) was prepared in the same manner as Synthesis Example 1, except that the dispersant D was changed to the absolutely dried polymer P-2 produced in Production Example 2. The copper nanoparticles A-2 had an average particle size of 200 nm and a dispersant mass ratio of 0.010.

Synthesis Example 3 (dry powder of copper nanoparticles A-3 containing polymer P-2)

A dry powder of copper nanoparticles A-3 containing the polymer P-2 (also referred to as a "dry powder of the copper nanoparticles A-3" below) was prepared in the same manner as Synthesis Example 2, except that the amount of the absolutely dried polymer P-2 added was changed to 0.4 g. The copper nanoparticles A-3 had an average particle size of 300 nm and a dispersant mass ratio of 0.006.

(Preparation of dispersion of modified cellulose B)

Preparation Example 1 (PEG200 dispersion of modified cellulose fibers BI-1)

(1) As natural cellulose, 10 g of bleached softwood kraft pulp (trade name: Hinton, manufactured by West Fraser Timber Co., Ltd.) was blended with 990 g of ion-exchanged water, and 0.13 g of TEMPO (free radical, 98% by mass, manufactured by Sigma-Aldrich), 1.3 g of sodium bromide, and 27 g of a 10.5% by mass aqueous solution of sodium hypochlorite (10.5% by mass aqueous solution) were added in this order with respect to 10 g of the pulp. Using an automatic titrator (AUT-701, manufactured by DKK-TOA CORPORATION) for pH-stat titration, a 0.5 M sodium hydroxide aqueous solution was added dropwise to maintain the pH at 10.5. The reaction was performed at 20°C for 120 minutes at a stirring speed of 200 rpm to prepare a suspension of modified cellulose fibers having carboxy groups as anionic groups (i.e., carboxy-modified cellulose fibers).

The pH of the suspension of the modified cellulose fibers was adjusted to 2 by addition of 0.01 M hydrochloric acid, and the modified cellulose fibers were thoroughly washed with ion-exchanged water until the filtrate had an electrical conductivity of 200 pS/cm or less as measured using a compact conductivity meter (LAQUAtwin EC-33B, manufactured by HORIBA, Ltd.). Then, the modified cellulose fibers were dehydrated into cake-like modified cellulose fibers. The modified cellulose fibers thus obtained had an average fiber length of 594 μm, an average fiber diameter of 2.7 μm, an aspect ratio of 220, and a carboxy group content of 1.5 mmol/g. The modified cellulose fibers were in the acid form.

(2) Next, 1.8 g of the cake-like modified cellulose fibers in terms of absolute dry mass, obtained in (1) above, were charged and blended with ion-exchanged water until the mass of the content reached 36 g. The mixture was then treated at 95°C for 3 hours with stirring to prepare an aqueous suspension of shortened modified cellulose fibers. The modified cellulose fibers had an average fiber length of 210 μm, an average fiber diameter of 3.3 μm, an aspect ratio of 64, and a carboxy group content of 1.5 mmol/g. The modified cellulose fibers were in the acid form.

(3) The aqueous suspension of the shortened modified cellulose fibers, obtained in (2) above, was washed three times with polyethylene glycol 200 (abbreviated as "PEG200," first-grade reagent, manufactured by FUJIFILM Wako Pure Chemical Corporation) to replace the dispersion medium. Then, 11.2 g of the resulting gel (solid content: 13.4% by mass) and 4 g of methoxypoly(oxyethylene/oxypropylene)-2-propylamine (abbreviated as "EOPO amine," JEFFAMINE M-2070, manufactured by Huntsman Corporation, U.SA, PO/EO (molar ratio) = 10/31), corresponding to 1 equivalent of the carboxy group of the modified cellulose fibers, were placed in a beaker and mixed together. Further, 14.8 g of the PEG200 was added to the mixture to make a total of 30 g. This solution was stirred at room temperature for 1 hour with a mechanical stirrer, and then treated using a high-pressure homogenizer (trade name: Nanovater L-ES, manufactured by YOSHIDA KIKAI CO., LTD.) at 150 MPa for five passes, resulting in a PEG200 dispersion of modified cellulose fibers BI-1, to which

the EOPO amine was linked via ionic bonds (the content of the modified cellulose fibers BI-1 (the solid content of modified cellulose): 5% by mass, dispersion medium C: PEG200). The modified cellulose fibers BI-1 had a degree of crystallinity of 43%, an average fiber diameter of 4 nm, an average fiber length of 350 nm, and an average aspect ratio of 88.

Preparation Example 2 (PEG200 dispersion of modified cellulose fibers BI-2)

A PEG200 dispersion of modified cellulose fibers BI-2, to which tetrabutylammonium was linked via ionic bonds (the content of the modified cellulose fibers BI-2 (the solid content of modified cellulose): 5% by mass, dispersion medium C: PEG200) was prepared in the same manner as Preparation Example 1, except that 4 g of the EOPO amine for the modified cellulose fibers BI-1 was changed to 2.0 g of a 25% by mass aqueous solution of tetrabutylammonium hydroxide (abbreviated as "TBAH"), and the amount of the PEG200 was changed from 14.8 g to 16.8 g in (3) of Preparation Example 1. The modified cellulose fibers BI-2 had a degree of crystallinity of 43%, an average fiber diameter of 4 nm, an average fiber length of 350 nm, and an aspect ratio of 88.

Preparation Example 3 (PEG200 dispersion of modified cellulose fibers BII-3)

The aqueous suspension of the shortened modified cellulose fibers, obtained in (2) of Preparation Example 1, was washed three times with the PEG200 to replace the dispersion medium. Then, 11.2 g of the resulting gel (solid content: 13.4% by mass) and 4 g of the EOPO amine were placed in a beaker and mixed together. Moreover, 0.26 g of 4-methylmorpholine, 1.49 g of 4-(4,6-dimethoxy-1,3,5-triazin-2-y])-4-methylmorpholinium chloride (abbreviated as "DMT-MM," condensation agent, manufactured by Tokyo Chemical Industry Co., Ltd.), and 300 g of the PEG200 were added to the mixture. This solution was stirred at room temperature for 14 hours with a mechanical stirrer so that the reaction proceeded. After completion of the reaction, the solution was filtered, and the residue was washed with ethanol to remove DMT-MM salts and further washed and replaced with the PEG200 to make a total of 30 g. The resulting solution was then treated using a high-pressure homogenizer (trade name: Nanovater L-ES, manufactured by YOSHIDA KIKAI CO., LTD.) at 150 MPa for five passes, resulting in a PEG200 dispersion of modified cellulose fibers BII-3, to which the EOPO amine was linked via amide bonds (the content of the modified cellulose fibers BII-3 (the solid content of modified cellulose): 5% by mass, dispersion medium C: PEG200). The modified cellulose fibers BII-3 had a degree of crystallinity of 43%, an average fiber diameter of 3 nm, an average fiber length of 300 nm, and an aspect ratio of 100.

Preparation Example 4 (PEG200 dispersion of modified cellulose fibers BII-4)

(1) As natural cellulose, 10 g of bleached softwood kraft pulp (trade name: Hinton, manufactured by West Fraser Timber Co., Ltd.) was immersed in 400 g of a 20% by mass sodium hydroxide solution and stirred at a stirring speed of 200 rpm for 5 minutes (30°C). Then, the slurry was subjected to pressure filtration to obtain a wet cake. The wet cake was immersed in 400 g of ion-exchanged water and stirred at a stirring speed of 200 rpm, while the pH was adjusted to 2 by addition of 0.01 M hydrochloric acid. Thereafter, the pulp was thoroughly washed with ion-exchanged water until the filtrate had an electrical conductivity of 200 pS/cm or less as measured using a compact conductivity meter (LAQUAtwin EC-33B, manufactured by HORIBA, Ltd.). Subsequently, the pulp was dehydrated and dried until the solid content reached 99.5% by mass or more, thereby providing pulp that had undergone immersion in sodium hydroxide.

(2) A PEG200 dispersion of modified cellulose fibers BII-4, to which the EOPO amine was linked via amide bonds (the content of the modified cellulose fibers BII-4 (the solid oontent of modified cellulose): 5% by mass, dispersion medium C: PEG200) was prepared in the same manner as (1) and (2) of Preparation Example 1, where the aqueous suspension of the shortened modified cellulose fibers was obtained, followed by the operation of Preparation Example 3, except that 10 g of the pulp that had undergone immersion in sodium hydroxide, obtained in (1) above, was used instead of 10 g of the bleached softwood kraft pulp (trade name: Hinton, manufactured by West Fraser Timber Co., Ltd.) as natural cellulose. The modified cellulose fibers BII-4 had a degree of crystallinity of 25%, an average fiber diameter of 3 nm, an average fiber length of 260 nm, and an aspect ratio of 87.

Preparation Example 5 (PEG200 dispersion of modified cellulose fibers BH-5)

The aqueous suspension of the shortened modified cellulose fibers, obtained in (2) of Preparation Example 1, was washed three times with the PEG200 to replace the dispersion medium. Then, 11.2 g of the resulting gel (solid content: 13.4% by mass) and 4 g of octylamine (guaranteed reagent, manufactured by FUJIFILM Wako Pure Chemical Corporation) were placed in a beaker and mixed together. Moreover, 0.26 g of 4-methylmorpholine, 1.49 g of the DMT-MM (condensation agent), and 300 g of the PEG200 were added to the mixture. This solution was stirred at room temperature for 14 hours with a mechanical stirrer so that the reaction proceeded. After completion of the reaction, the solution was filtered, and the residue was washed with ethanol to remove DMT-MM salts and further washed and replaced with the

PEG200 to make a total of 30 g. The resulting solution was then treated using a high-pressure homogenizer (trade name: Nanovater L-ES, manufactured by YOSHIDA KIKAI CO., LTD.) at 150 MPa for five passes, resulting in a PEG200 dispersion of modified cellulose fibers BII-5, to which the octylamine was linked via amide bonds (the content of the modified cellulose fibers BII-5 (the solid content of modified cellulose): 5% by mass, dispersion medium C: PEG200). The modified cellulose fibers BII-5 had a degree of crystallinity of 43%, an average fiber diameter of 3 nm, an average fiber length of 300 nm, and an aspect ratio of 100.

Comparative Preparation Example 1 (PEG200 dispersion of modified cellulose BC-1)

As ethyl cellulose, 100 g of Ethyl Cellulose 5% in Toluene + Ethanol (80:20) (manufactured by Tokyo Chemical Industry Co., Ltd.) was used and immersed in 95 g of the PEG200, which was then stirred in air at 2,000 rpm for 5 minutes with a vacuum rotation-revolution mixer (ARV-310P, manufactured by THINKY CORPORATION). Thereafter, stirring at 2,000 rpm for 5 minutes was repeated five times under vacuum to evaporate the toluene and the ethanol, resulting in a PEG200 dispersion of ethyl cellulose (modified cellulose BC-1) (the content of the modified cellulose BC-1 (the solid content of modified cellulose): 5% by mass, dispersion medium C: PEG200). The degree of crystallinity was 0%.

Comparative Preparation Example 2 (PEG200 dispersion of modified cellulose fibers BC-2)

The aqueous suspension of the shortened modified cellulose fibers, obtained in (2) of Preparation Example 1, was washed three times with the PEG200 to replace the dispersion medium. Then, 11.2 g of the resulting gel (solid content: 13.4% by mass) and 18.8 g of the PEG200 were placed in a beaker and mixed together to make a total of 30 g. This solution was stirred at room temperature for 1 hour with a mechanical stirrer, and then treated using a high-pressure homogenizer (trade name: Nanovater L-ES, manufactured by YOSHIDA KIKAI CO., LTD.) at 150 MPa for five passes, resulting in a PEG200 dispersion of modified cellulose fibers BC-2 (the content of the modified cellulose fibers BC-2 (the solid content of modified cellulose): 5% by mass, dispersion medium C: PEG200). The modified cellulose fibers BC-2 had a degree of crystallinity of 43%, an average fiber diameter of 8 nm, an average fiber length of 600 nm, and an average aspect ratio of 75.

Table 2 shows the physical properties and structures of the modified cellulose B in each of Preparation Examples 1 to 5.

[TABLE 2]

| | | Preparation Example | | | | |
|---|---|---|---|---|---|---|
| | | 1 | 2 | 3 | 4 | 5 |
| Modified cellulose B | | BI-1 | BI-2 | BII-3 | BII-4 | BII-5 |
| Properties | Degree of crystallinity (%) | 43 | 43 | 43 | 25 | 43 |
| | Average fiber diameter (nm) | 4 | 4 | 3 | 3 | 3 |
| | Average fiber length (nm) | 350 | 350 | 300 | 260 | 300 |
| | Average aspect ratio | 88 | 88 | 100 | 87 | 100 |
| Modifying compound or modifying group | | EOPO amine | TBAH | EOPO amine | EOPO amine | octylamine |
| Bonding type of modifying group | | ionic bond | ionic bond | amide bond | amide bond | amide bond |
| Binding amount of modifying group (mmol/g) | | 3.00 | 3.00 | 2.78 | 3.06 | 2.78 |
| Introduction rate of modifying group (mol%) | | 50 | 50 | 54 | 49 | 54 |

Example 1

(preparation of copper fine particle dispersion)

0.3 g of diethylene glycol (first-grade reagent, manufactured by FUJIFILM Wako Pure Chemical Corporation), 0.3 g of PEG200 (first-grade reagent, manufactured by FUJIFILM Wako Pure Chemical Corporation), 0.1 g of the PEG200 dispersion of the modified cellulose fibers BF1, and 9.3 g of the dry powder of the copper nanoparticles A-1 containing the polymer P-1 were placed in an agate mortar and kneaded until the dry powder was no longer visible to the naked eye, and the resulting mixture was transferred to a plastic bottle. Then, the sealed plastic bottle was stirred at 2,000 $min^{-1}$ (2,000 rpm) for 5 minutes with a rotation-revolution mixer (Planetary Vacuum Mixer ARV-310, manufactured by THINKY CORPORATION). Thus, a copper fine particle dispersion of Example 1 was produced.

Examples 2 to 20 and Comparative Examples 1 to 6

Copper fine particle dispersions of Examples 2 to 20 and Comparative Examples 1 to 6 were produced in the same manner as Example 1, except that the compositions of the copper fine particle dispersions were changed to those shown in Tables 3 and 4.

The materials used in the production of the copper fine particle dispersions are as follows.

(Copper nanoparticles A)

Dry powder of copper nanoparticles A-4: CH-0200 L1 (manufactured by MITSUI MINING & SMELTING CO., LTD., the copper nanoparticles A-4 having an average particle size of 190 nm and containing 1.3% by mass of lauric acid as a dispersant D)

(Dispersion medium C)

Diethylene glycol: first-grade reagent, manufactured by FUJIFILM Wako Pure Chemical Corporation

PEG200: polyethylene glycol 200, first-grade reagent, manufactured by FUJIFILM Wako Pure Chemical Corporation, average molecular weight: 180 to 220

$\alpha$-terpineol: guaranteed reagent, manufactured by FUJIFILM Wako Pure Chemical Corporation

Diethylene glycol monobutyl ether: guaranteed reagent, manufactured by FUJIFILM Wako Pure Chemical Corporation

(Copper microparticles)

MA-C025 (manufactured by MITSUI MINING & SMELTING CO., LTD., average particle size: 5.0 $\mu$m)

1050Y (manufactured by MITSUI MINING & SMELTING CO., LTD., average particle size: 0.8 $\mu$m)

(Surfactant)

SURFYNOL 104: 2,4,7,9-tetramethyl-5-decyne-4,7-diol, manufactured by Nissin Chemical Industry Co., Ltd.

SURFYNOL 420: EO adduct of 2,4,7,9-tetramethyl-5-decyne-4,7-diol, average number of moles of EO added: 1.3, manufactured by Nissin Chemical Industry Co., Ltd.

SURFYNOL 465: EO adduct of 2,4,7,9-tetramethyl-5-decyne-4,7-diol, average number of moles of EO added: 10, manufactured by Nissin Chemical Industry Co., Ltd.

The following evaluations were performed on the copper fine particle dispersions of Examples 1 to 20 and Comparative Examples 1 to 6. Tables 3 and 4 shows the results.

<Evaluation>

[Printing dimensional properties]

The printing dimensional properties of the copper fine particle dispersion produced in each of Examples and Comparative Examples were evaluated according to the following procedure.

First, a stainless steel metal mask (thickness: 150 $\mu$m) having three rows of 6 mm $\times$ 6 mm square openings was placed on a 30 mm $\times$30 mm copper plate (thickness: 1 mm), and the copper fine particle dispersion was applied to the copper plate by stencil printing using a metal squeegee. Then, the width and length (unit:mm) of three images of the copper fine particle dispersion transferred onto the copper plate were measured with a digital microscope (product name: VHX-7000, manufactured by KEYENCE CORPORATION). Thereafter, the printing dimensional properties were calculated by the following formula (I). The printing dimensional properties were calculated for each of the three images of the copper fine particle dispersion transferred onto the copper plate, and the average of the values calculated from the three images was defined as the printing dimensional properties of the copper particulate dispersion. In this case, the lower the value, the better the printing dimensional properties.

$$\text{Printing dimensional properties (\%)} = [(\text{length} + \text{width}) / (6\text{mm} + 6\text{mm}) - 1] \times 100 \quad (\text{I})$$

[Bonding strength]

The bonding strength of the copper fine particle dispersion produced in each of Examples and Comparative Examples was measured according to the following procedure.

First, a stainless steel metal mask (thickness: 150 μm) having three rows of 6 mm × 6 mm square openings was placed on a 30 mm × 30 mm copper plate (thickness: 1 mm), and the copper fine particle dispersion was applied to the copper plate by stencil printing using a metal squeegee. Then, the copper plate coated with the copper fine particle dispersion was heated and dried at 120°C for 10 minutes in an air atmosphere on a Shamal Hot Plate (model number: HHP-441, manufactured by AS ONE CORPORATION). Next, a 5 mm × 5 mm silicon chip (thickness: 400 μm) sputtered with titanium, nickel, and gold in this order was prepared. This silicon chip was placed on the copper fine particle dispersion that had been applied to the copper plate so that the gold layer came into contact with the copper fine particle dispersion. As a result, a layered body in which the copper plate, the copper fine particle dispersion, and the silicon chip were stacked in this order was provided.

The layered body was sintered in the following manner, providing a bonded body.

First, the layered body was set in a pressure and heat bonding apparatus (model number: HTM-1000, manufactured by MEISYO KIKO CO., LTD), and nitrogen was flowed into the furnace at 500 mL/min to replace the air in the furnace with nitrogen. Then, the layered body was pressed at 20 MPa between upper and lower heating heads while the temperature of the heating heads was increased to 250°C over 10 minutes. After increasing the temperature, the layered body was held at 250°C for 150 seconds and sintered to form a bonded body. After the sintering was finished, the heating heads were water-cooled at - 60°C/min, and the bonded body was taken out of the apparatus into the air when the temperature of the heating heads reached 100°C or less.

The die shear strength of the bonded body thus obtained was measured by pressing the silicon chip of the bonded body in the horizontal direction at a test speed of 5 mm/min and a shear height of 50 pm using a universal bond tester (product name: Material Tester, model number: Prospector, manufactured by Nordson Advanced Technology KK). The test was performed on three samples of each bonded body, and the average of the measured values of the three bonded bodies was defined as the bonding strength of the bonded body. The larger the value of the bonding strength, the better the bonding properties.

[250°C heat resistance]

The 250°C heat resistance of the copper fine particle dispersion produced in each of Examples 1 and 7 was measured according to the following procedure.

The bonded body obtained in the above bonding strength measurement was stored at 250°C for 1000 hours in an air atmosphere under atmospheric pressure, and then the bonding strength of the bonded body after storage at 250°C for 1000 hours was measured in the same manner as the above method for evaluating the bonding strength.

The 250°C heat resistance of the copper fine particle dispersions of Examples 1 and 7 was 28 MPa and 38 MPa, respectively.

[TABLE 3]

| Copper fine particle dispersion | | | Example | | | | | | | Comparative Example | | | | | |
|---|---|---|---|---|---|---|---|---|---|---|---|---|---|---|---|
| | | | 1 | 2 | 3 | 4 | 5 | 6 | 7 | 1 | 2 | 3 | 4 | 5 | 6 |
| Composition | Dry powder of copper nanoparticles A | Blending amount (parts by mass) | 93 | 93 | 93 | 93 | 53 | 53 | 53 | | 93 | 93 | 93 | 93 | 93 |
| | | Type of copper nanoparticles A | A-1 | A-2 | A-3 | A-4 | A-1 | A-1 | A-1 | | A-1 | A-1 | A-1 | A-1 | A-1 |
| | | Average particle size of copper nanoparticles A (nm) | 120 | 200 | 300 | 190 | 120 | 120 | 120 | | 120 | 120 | 120 | 120 | 120 |
| | | Type of dispersant D | P-1 | P-2 | P-2 | lauric acid | P-1 | P-1 | P-1 | | P-1 | P-1 | P-1 | P-1 | P-1 |
| | | Mass ratio [dispersant D/(copper nanoparticles A + dispersant D)] | 0.016 | 0.010 | 0.006 | 0.013 | 0.016 | 0.016 | 0.016 | | 0.016 | 0.016 | 0.016 | 0.016 | 0.016 |
| | PEG200 dispersion of modified cellulose B | Blending amount (parts by mass) | 1 | 1 | 1 | 1 | 1 | 1 | 1 | 1 | 1 | 6.3 | 1 | 6.3 | 6.3 |
| | | Type of modified cellulose B | BI-1 | BI-1 | BI-1 | BI-1 | BI-1 | BI-1 | BII-3 | BI-1 | BC-1 | BC-1 | BC-2 | BC-2 | BII-3 |
| | | Degree of crystallinity of modified cellulose B (%) | 43 | 43 | 43 | 43 | 43 | 43 | 43 | 43 | 0 | 0 | 43 | 43 | 43 |
| | Diethylene glycol | Blending amount (parts by mass) | 3 | 3 | 3 | 3 | 3 | 3 | 3 | 3 | 3 | 3 | 3 | 3 | 3 |

(continued)

| Copper fine particle dispersion | | | Example | | | | | | | Comparative Example | | | | | |
|---|---|---|---|---|---|---|---|---|---|---|---|---|---|---|---|
| | | | 1 | 2 | 3 | 4 | 5 | 6 | 7 | 1 | 2 | 3 | 4 | 5 | 6 |
| | PEG200 | Blending amount (parts by mass) | 3 | 3 | 3 | 3 | 3 | 3 | 3 | 3 | 3 | 2.7 | 3 | 2.7 | 2.7 |
| | Copper microparticles | Blending amount (parts by mass) | | | | | 40 | 40 | 40 | 93 | | | | | |
| | | Tyoe | | | | | 1050Y | MA-C025 | 1050Y | 1050Y | | | | | |
| | | Average particle size ($\mu m$) | | | | | 0.8 | 5.0 | 0.8 | 0.8 | | | | | |
| Content of copper nanoparticles A (% by mass) | | | 92 | 92 | 92 | 92 | 52 | 52 | 52 | 0 | 92 | 87 | 92 | 87 | 87 |
| Content of modified cellulose B (ppm by mass) | | | 500 | 500 | 500 | 500 | 500 | 500 | 500 | 500 | 500 | 3000 | 500 | 3000 | 3000 |
| Mass ratio [modified cellulose B/dispersion medium C] | | | 0.0072 | 0.0072 | 0.0072 | 0.0072 | 0.0072 | 0.0072 | 0.0072 | 0.0072 | 0.0072 | 0.0270 | 0.0072 | 0.0270 | 0.0270 |
| Mass ratio [modified cellulose B/copper nanoparticles A] | | | 0.0005 | 0.0005 | 0.0005 | 0.0005 | 0.0010 | 0.0010 | 0.0010 | - | 0.0005 | 0.0034 | 0.0005 | 0.0034 | 0.0034 |
| Evaluation | Printing dimensional properties (%) | | 3 | 4 | 7 | 4 | 8 | 8 | 2 | 11 | 13 | 3 | 16 | 10 | 1 |
| | Bonding strength (MPa) | | 30 | 34 | 26 | 29 | 36 | 39 | 39 | 5 | 29 | 10 | 29 | 9 | 12 |

[TABLE 4]

| Copper fine particle dispersion | | | Example | | | | | | | | | | | | | |
|---|---|---|---|---|---|---|---|---|---|---|---|---|---|---|---|---|
| | | | 1 | 8 | 9 | 10 | 11 | 12 | 13 | 14 | 15 | 16 | 17 | 18 | 19 | 20 |
| Composition | Dry powder of copper nanoparticles A | Blending amount (parts by mass) | 93 | 93 | 93 | 93 | 93 | 93 | 93 | 93 | 93 | 93 | 93 | 93 | 93 | 93 |
| | | Type of copper nanoparticles A | A-1 | A-1 | A-1 | A-1 | A-1 | A-1 | A-1 | A-1 | A-1 | A-1 | A-1 | A-1 | A-1 | A-1 |
| | | Average particle size of copper nanoparticles A (nm) | 120 | 120 | 120 | 120 | 120 | 120 | 120 | 120 | 120 | 120 | 120 | 120 | 120 | 120 |
| | | Type of dispersant D | P-1 | P-1 | P-1 | P-1 | P-1 | P-1 | P-1 | P-1 | P-1 | P-1 | P-1 | P-1 | P-1 | P-1 |
| | | Mass ratio [dispersant D/(copper nanoparticles A + dispersant D)] | 0.016 | 0.016 | 0.016 | 0.016 | 0.016 | 0.016 | 0.016 | 0.016 | 0.016 | 0.016 | 0.016 | 0.016 | 0.016 | 0.016 |
| | PEG200 dispersion of modified cellulose B | Blending amount (parts by mass) | 1 | 1 | 1 | 1 | 1 | 0.03 | 0.3 | 0.5 | 4 | 1 | 1 | 1 | 1 | 1 |
| | | Type of modified cellulose B | BI-1 | BI-2 | BII-3 | BII-4 | BII-5 | BII-3 | BII-3 | BII-3 | BII-3 | BI-1 | BI-1 | BII-3 | BII-3 | BII-3 |
| | | Degree of crystallinity of modified cellulose B (%) | 43 | 43 | 43 | 25 | 43 | 43 | 43 | 43 | 43 | 43 | 43 | 43 | 43 | 43 |
| | Diethylene glycol | Blending amount (parts by mass) | 3 | 3 | 3 | 3 | 3 | 3 | 3 | 3 | 2 | | | 3 | 3 | 3 |
| | PEG200 | Blending amount (parts by mass) | 3 | 3 | 3 | 3 | 3 | 4 | 3.7 | 3.5 | 1 | 3 | 3 | 2.5 | 2.5 | 2.9 |

(continued)

| Copper fine particle dispersion | | | Example | | | | | | | | | | | | | |
|---|---|---|---|---|---|---|---|---|---|---|---|---|---|---|---|---|
| | | | 1 | 8 | 9 | 10 | 11 | 12 | 13 | 14 | 15 | 16 | 17 | 18 | 19 | 20 |
| | $\alpha$-terpineol | Blending amount (parts by mass) | | | | | | | | | | 3 | | | | |
| | Diethylene glycol monobutyl ether | Blending amount (parts by mass) | | | | | | | | | | | 3 | | | |
| | SURFYNOL 104 | Blending amount (parts by mass) | | | | | | | | | | | | 0.5 | | |
| | SURFYNOL 420 | Blending amount (parts by mass) | | | | | | | | | | | | | 0.5 | |
| | SURFYNOL 465 | Blending amount (parts by mass) | | | | | | | | | | | | | | 0.1 |
| Content of copper nanoparticles A (% by mass) | | | 92 | 92 | 92 | 92 | 92 | 92 | 92 | 92 | 92 | 92 | 92 | 92 | 92 | 92 |
| Content of modified cellulose B (ppm by mass) | | | 500 | 500 | 500 | 500 | 500 | 15 | 150 | 250 | 2000 | 500 | 500 | 500 | 500 | 500 |
| Mass ratio [modified cellulose B/dispersion medium C] | | | 0.0072 | 0.0072 | 0.0072 | 0.0072 | 0.0072 | 0.0002 | 0.0021 | 0.0036 | 0.0294 | 0.0072 | 0.0072 | 0.0072 | 0.0072 | 0.0072 |
| Mass ratio [modified cellulose B/copper nanoparticles A] | | | 0.0005 | 0.0005 | 0.0005 | 0.0005 | 0.0005 | 0.00002 | 0.0002 | 0.0003 | 0.0022 | 0.0005 | 0.0005 | 0.0005 | 0.0005 | 0.0005 |
| Evaluation | Printing dimensional properties (%) | | 3 | 3 | 1 | 5 | 1 | 7 | 3 | 2 | 1 | 3 | 4 | 1 | 1 | 1 |
| | Bonding strength (MPa) | | 30 | 30 | 31 | 30 | 29 | 44 | 40 | 40 | 22 | 29 | 29 | 32 | 31 | 31 |

The copper fine particle dispersions of Examples 1 to 20 had better printing dimensional properties and higher bonding strength of the bonded bodies than the copper fine particle dispersions of Comparative Examples 1 to 6. These results confirm that the copper fine particle dispersion of the present invention has excellent printing dimensional properties, and that the bonded body produced using the copper fine particle dispersion of the present invention has high bonding strength.

The bonded bodies produced using the copper fine particle dispersions of Examples 1 and 7 also had better 250°C heat resistance. Therefore, the copper fine particle dispersion of the present invention also has excellent 250°C heat resistance.

## Claims

1. A copper fine particle dispersion comprising copper nanoparticles A, modified cellulose B, and a dispersion medium C,

    wherein an average particle size of the copper nanoparticles A is 50 nm or more and 350 nm or less,
    a content of the modified cellulose B in the copper fine particle dispersion is 2,500 ppm by mass or less,
    the modified cellulose B is in the form of anion-modified cellulose fibers with modifying groups, and
    the modifying groups comprise one or more selected from the group consisting of a hydrocarbon group (a) and a polymer group (b).

2. The copper fine particle dispersion according to claim 1, wherein the modified cellulose B comprises one or more types of modified cellulose fibers (I) selected from the group consisting of modified cellulose fibers (BI) having the modifying groups bound via ionic bonds to anionic groups of the anion-modified cellulose fibers and modified cellulose fibers (BII) having the modifying groups introduced by amidation of carboxy groups that are anionic groups of the anion-modified cellulose fibers.

3. The copper fine particle dispersion according to claim 2, wherein a degree of crystallinity of the modified cellulose fibers (I) is 20% or more and 90% or less.

4. The copper fine particle dispersion according to claim 2 or 3, wherein an average fiber diameter of the modified cellulose fibers (I) is 1 nm or more and 300 nm or less.

5. The copper fine particle dispersion according to any one of claims 1 to 4, wherein a mass ratio [modified cellulose B/dispersion medium C] of the content of the modified cellulose B to a content of the dispersion medium C is 0.0001 or more and 0.1 or less.

6. The copper fine particle dispersion according to any one of claims 1 to 5, wherein a mass ratio [modified cellulose B/copper nanoparticles A] of the content of the modified cellulose B to a content of the copper nanoparticles A is 0.00001 or more and 0.01 or less.

7. The copper fine particle dispersion according to any one of claims 1 to 6, wherein a boiling point of the dispersion medium C at 1 atm is 180°C or more and 400°C or less.

8. The copper fine particle dispersion according to any one of claims 1 to 7, wherein the content of the copper nanoparticles A in the copper fine particle dispersion is 30% by mass or more and 95% by mass or less.

9. The copper fine particle dispersion according to any one of claims 1 to 8, further comprising copper microparticles, wherein an average particle size of the copper microparticles is more than 0.35 pm and 10 pm or less.

10. A copper fine particle dispersion comprising copper nanoparticles A, modified cellulose B, and a dispersion medium C,

    wherein an average particle size of the copper nanoparticles A is 50 nm or more and 350 nm or less,
    a content of the modified cellulose B in the copper fine particle dispersion is 2,500 ppm by mass or less,
    the modified cellulose B is in the form of anion-modified cellulose fibers with modifying groups,
    the modifying groups comprise one or more selected from the group consisting of a hydrocarbon group (a) and a polymer group (b),

the modified cellulose B comprises one or more types of modified cellulose fibers (I) selected from the group consisting of modified cellulose fibers (BI) having the modifying groups bound via ionic bonds to anionic groups of the anion-modified cellulose fibers and modified cellulose fibers (BII) having the modifying groups introduced by amidation of carboxy groups that are anionic groups of the anion-modified cellulose fibers, and
a degree of crystallinity of the modified cellulose fibers (I) is 20% or more and 90% or less.

**11.** A copper fine particle dispersion comprising copper nanoparticles A, modified cellulose B, and a dispersion medium C,

wherein an average particle size of the copper nanoparticles A is 50 nm or more and 350 nm or less,
a content of the modified cellulose B in the copper fine particle dispersion is 2,500 ppm by mass or less,
the modified cellulose B is in the form of anion-modified cellulose fibers with modifying groups,
the modifying groups comprise one or more selected from the group consisting of a hydrocarbon group (a) and a polymer group (b),
the modified cellulose B comprises modified cellulose fibers (BI) having the modifying groups bound via ionic bonds to anionic groups of the anion-modified cellulose fibers, and the anion-modified cellulose fibers are modified cellulose fibers in which carbon atoms at C6 positions of glucose units in cellulose fibers constitute carboxy groups, and
a degree of crystallinity of the modified cellulose fibers (BI) is 20% or more and 90% or less.

**12.** The copper fine particle dispersion according to claim 11, wherein the modified cellulose fibers (BI) have a structure represented by the following formula (2):

[Chemical Formula 1]

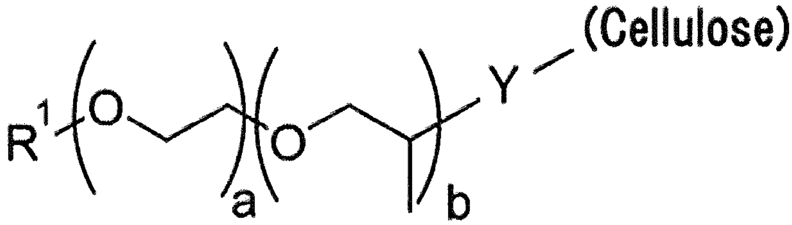

(2)

in the formula (2), Y represents an ionic bond, $R^1$ represents a hydrogen atom or a hydrocarbon group having 1 to 6 carbon atoms, ethylene oxide-derived units and propylene oxide-derived units are present in a random or block form, a represents a positive number indicating an average number of moles of ethylene oxide added, and b represents a positive number indicating an average number of moles of propylene oxide added.

**13.** A copper fine particle dispersion comprising copper nanoparticles A, modified cellulose B, and a dispersion medium C,

wherein an average particle size of the copper nanoparticles A is 50 nm or more and 350 nm or less,
a content of the modified cellulose B in the copper fine particle dispersion is 2,500 ppm by mass or less,
the modified cellulose B is in the form of anion-modified cellulose fibers with modifying groups,
the modifying groups comprise one or more selected from the group consisting of a hydrocarbon group (a) and a polymer group (b),
the modified cellulose B comprises modified cellulose fibers (BII) having the modifying groups introduced by amidation of carboxy groups that are anionic groups of the anion-modified cellulose fibers, and the modified cellulose fibers (BII) are modified cellulose fibers in which carbon atoms at C6 positions of glucose units in the anion-modified cellulose fibers constitute amide bonds and the modifying groups are bound via the amide bonds, and
a degree of crystallinity of the modified cellulose fibers (BII) is 20% or more and 90% or less.

**14.** The copper fine particle dispersion according to claim 13, wherein the modified cellulose fibers (BII) have a structure represented by the following formula (3):

[Chemical Formula 2]

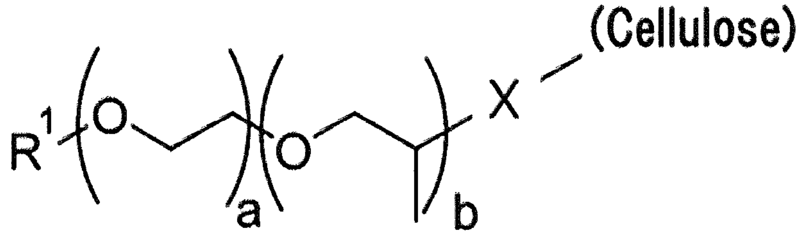

(3)

in the formula (3), X represents an amide bond, $R^1$ represents a hydrogen atom or a hydrocarbon group having 1 to 6 carbon atoms, ethylene oxide-derived units and propylene oxide-derived units are present in a random or block form, a represents a positive number indicating an average number of moles of ethylene oxide added, and b represents a positive number indicating an average number of moles of propylene oxide added.

**15.** A copper fine particle dispersion comprising copper nanoparticles A, modified cellulose B, a dispersion medium C, and copper microparticles,

wherein an average particle size of the copper nanoparticles A is 50 nm or more and 350 nm or less,
a content of the modified cellulose B in the copper fine particle dispersion is 2,500 ppm by mass or less,
the modified cellulose B is in the form of anion-modified cellulose fibers with modifying groups,
the modifying groups comprise one or more selected from the group consisting of a hydrocarbon group (a) and a polymer group (b),
the modified cellulose B comprises one or more types of modified cellulose fibers (I) selected from the group consisting of modified cellulose fibers (BI) having the modifying groups bound via ionic bonds to anionic groups of the anion-modified cellulose fibers and modified cellulose fibers (BII) having the modifying groups introduced by amidation of carboxy groups that are anionic groups of the anion-modified cellulose fibers,
a degree of crystallinity of the modified cellulose fibers (I) is 20% or more and 90% or less, and
an average particle size of the copper microparticles is more than 0.35 μm and 10 μm or less.

**16.** A copper fine particle dispersion comprising copper nanoparticles A, modified cellulose B, a dispersion medium C, a dispersant D, and copper microparticles,

wherein the copper nanoparticles A are dispersed with the dispersant D,
an average particle size of the copper nanoparticles A is 50 nm or more and 350 nm or less,
a content of the modified cellulose B in the copper fine particle dispersion is 2,500 ppm by mass or less,
the modified cellulose B is in the form of anion-modified cellulose fibers with modifying groups,
the modifying groups comprise one or more selected from the group consisting of a hydrocarbon group (a) and a polymer group (b),
the modified cellulose B comprises one or more types of modified cellulose fibers (I) selected from the group consisting of modified cellulose fibers (BI) having the modifying groups bound via ionic bonds to anionic groups of the anion-modified cellulose fibers and modified cellulose fibers (BII) having the modifying groups introduced by amidation of carboxy groups that are anionic groups of the anion-modified cellulose fibers,
a degree of crystallinity of the modified cellulose fibers (I) is 20% or more and 90% or less, and
an average particle size of the copper microparticles is more than 0.35 pm and 10 pm or less.

**17.** The copper fine particle dispersion according to any one of claims 1 to 16, used for bonding of multiple metal members.

**18.** A method for producing a bonded body, comprising:
heating multiple metal members with the copper fine particle dispersion according to any one of claims 1 to 16 interposed between the adjacent metal members.

**19.** Use of the copper fine particle dispersion according to any one of claims 1 to 16 as a bonding material paste.

## INTERNATIONAL SEARCH REPORT

International application No.
**PCT/JP2024/009235**

**A. CLASSIFICATION OF SUBJECT MATTER**

***B22F 1/00***(2022.01)i; ***B22F 9/00***(2006.01)i; ***H01B 1/22***(2006.01)i; ***H01L 21/52***(2006.01)i
FI: B22F1/00 L; B22F9/00 B; H01B1/22 A; H01L21/52 E

According to International Patent Classification (IPC) or to both national classification and IPC

**B. FIELDS SEARCHED**

Minimum documentation searched (classification system followed by classification symbols)

B22F1/00; B22F9/00; H01B1/22; H01L21/52

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br><br>Y | JP 2018-195540 A (TOPPAN PRINTING CO., LTD.) 06 December 2018 (2018-12-06) paragraphs [0009], [0018]-[0066] | 1, 4-6, 8<br><br>2-19 |
| Y | JP 2022-001634 A (KAO CORP.) 06 January 2022 (2022-01-06) paragraphs [0004], [0010]-[0092] | 2-19 |
| Y | JP 2019-175677 A (DKS CO. LTD.) 10 October 2019 (2019-10-10) paragraphs [0007], [0011]-[0032], [0050]-[0051] | 2-19 |
| Y | WO 2023/013034 A1 (KAO CORP.) 09 February 2023 (2023-02-09) paragraphs [0006]-[0065] | 7-9, 17-19 |

☐ Further documents are listed in the continuation of Box C.
☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **17 May 2024** | **04 June 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | <br><br>Telephone No. |

Form PCT/ISA/210 (second sheet) (July 2022)

**INTERNATIONAL SEARCH REPORT**
**Information on patent family members**

International application No.
**PCT/JP2024/009235**

| Patent document cited in search report | Publication date (day/month/year) | Patent family member(s) | Publication date (day/month/year) |
|---|---|---|---|
| JP 2018-195540 A | 06 December 2018 | (Family: none) | |
| JP 2022-001634 A | 06 January 2022 | WO 2021/230191 A1<br>CN 115335445 A<br>KR 10-2023-0009880 A | |
| JP 2019-175677 A | 10 October 2019 | WO 2019/188293 A1<br>TW 201946070 A | |
| WO 2023/013034 A1 | 09 February 2023 | CN 117794668 A<br>KR 10-2024-0029065 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2022013164 A
- JP 2015143336 A
- JP 2015143337 A